# EUROPEAN PATENT APPLICATION

(11) **EP 1 566 831 A2**
(43) Date of publication of application: **24.08.2005**
(21) Application number: 05250899.1
(22) Date of filing: 17.02.2005
(51) Int. Cl.: H01L 21/02, H01L 23/525

(54) **Semiconductor device and method for manufacturing it**

(30) Priority: 18.02.2004 JP 2004040910
(71) Applicant: Ricoh Company, Ltd., Tokyo 143-8555 (JP)
(72) Inventor: Hashimoto, Yasunori, Minou-gun, Hyogo (JP); Yamashita, Kimihiko, Kobe-shi, Hyogo (JP)
(74) Representative: Leeming, John Gerard

(57) **Abstract**

A semiconductor device includes: an insulating film; a metal thin-film resistance element; a wiring pattern formed on the insulating film, a part of which forms an electrode for electrically connecting with the metal thin-film resistance element; and a side wall produced at least on a side surface of the electrode of the wiring pattern, and made of an insulation material, wherein: the metal thin-film resistance element is produced across a top surface of the electrode and a surface of the insulating film via a surface of the side wall.

## Description

The present invention relates to a semiconductor device and a method for manufacturing it, and, in particular, to a semiconductor device having a metal thin-film resistance element made of a metal thin film produced on an insulating film and a manufacturing method therefor.

### 2. Description of the Related Art

In an analog integrated circuit, a resistance element is heavily used as an essential element. Recently, among various types of resistance elements, a resistance element made of a metal thin film (referred to as a metal thin-film resistance element) attracts an attention in terms of low temperature dependence of its resistance value (referred to as a TCR, hereinafter). As a material of the metal thin-film resistance element, for example, chrome silicon (CrSi), nickel chrome (NiCr), titanium nitride (TaN), chrome silicide (CrSi₂), chrome silicide nitride (CrSiN), chrome silicon oxy (CrSiO), or such is applied.

In a semiconductor device having the metal thin-film resistance element, in order to satisfy a demand for a highly integrated circuit, the metal thin-film resistance element having a thin film thinness less than 1000 Å is produced for achieving a higher sheet resistance, in many cases.

Conventionally, as a method to take an electric connection from the metal thin-film resistance element, the following methods exist:
1) a method of directly connecting a metal wiring to the metal thin-film resistance element (for example, see the patent document 1, listed below):
2) a method in which, after the metal thin-film resistance element is produced, an interlayer insulating film is produced, a connecting hole is produced in the interlayer insulating film, and a metal wiring is connected via the connecting hole (for example, see the patent documents 2 and 3, listed, below); and
3) a method in which a barrier film is produced on the metal thin-film resistance element, and a metal wiring is connected to the barrier film (for example, see patent documents 4 and 5, listed below).

The above-mentioned three methods 1), 2) and 3) to make electrical connections from the metal thin-film resistance element are described now in detail.

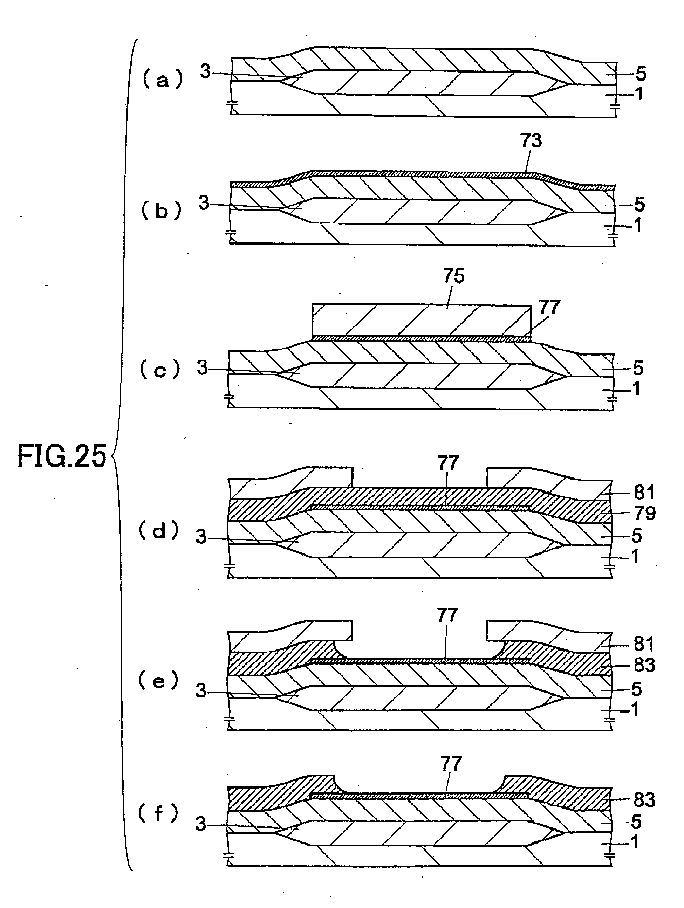

With reference to FIG. 25, the above-mentioned method 3) of directly producing a metal wiring on the metal thin-film resistance element is described first.
(1) On a wafer-shaped silicon substrate 1 on which production of a device separating oxide film 3 and a transistor device or such (not shown) is already completed, a BPSG (borophospho silicate glass) forming a first interlayer insulating film 5 between a gate electrode of the transistor and a metal wiring is produced, and reflow processing or such is carried out (see FIG. 25, (a)).
(2) A metal thin film 73 for producing the meal thin-film resistance element is produced on all the surface of the silicon substrate 1 for a film thickness on the order of a range between 20 and 500 Å (see FIG. 25 , (b)).
(3) On the metal thin film 73, a resist pattern 75 for defining an area for producing the metal thin-film resistance element is produced, and, with the use of the resist pattern 75 as a mask, the metal thin film is patterned, and thus, the metal thin-film resistance element 77 is produced (see FIG. 25, (c)).
(4) After removing the resist pattern 75, on all the surface of the first interlayer insulating film 5 including the metal thin-film resistance element 77, a wiring metal film 79 made of an AlSiCu film is produced. On the wiring metal film 79, a resist pattern 81 for patterning the wiring metal film 79 so as to leave it at both end parts of the metal thin-film resistance element 77 is produced (see FIG. 25, (d)).
(5) By means of wet etching technology, the wiring metal film 79 is patterned with the use of the resist pattern 81 as a mask, and the metal thin-film resistance element 83 is produced (see FIG. 25, (e)). In a common process of manufacturing a semiconductor device, dry etching technology is used for etching processing of the wiring metal film 79. However, it is not possible to apply the dry etching technology in a situation in which the metal thin-film resistance element 77 having a thin film thickness immediately below the wiring metal film, since over-etching may etch the metal thin-film resistance element 77 itself. Therefore, it is necessary to apply the wet etching technology to pattern the wiring metal film 79 in this case.
(6) By removing the resist pattern 81, production of the metal thin-film resistance element 77 and the metal wiring patterns 83 for making electrical connections from the metal thin-film resistance element 77 is completed (see FIG. 25, (f)).

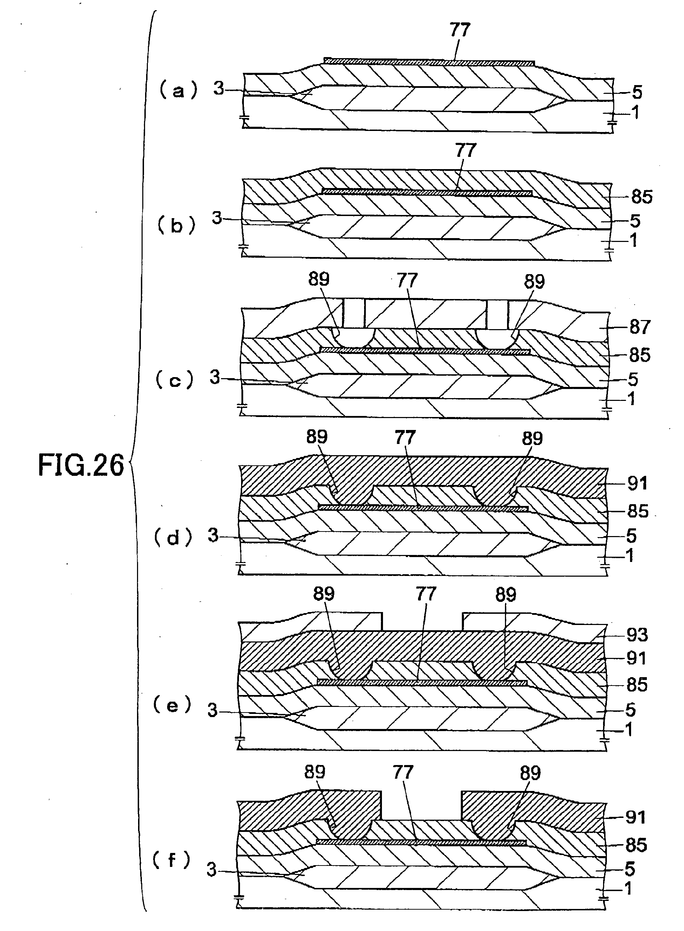

With reference to FIG. 26, the above-mentioned method 2) of producing an interlayer insulating film after producing the metal thin-film resistance element, forming a connecting hole in the interlayer insulating film, and connecting a metal wiring via the connecting hole is described next.
(1) In the same manner as the processes (1) through (3) described above with reference to FIG. 25, (a) through (c), the device separating oxide film 3, the first interlayer insulating film 5 and the metal thin-film resistance element 77 are produced (see FIG. 26, (a)).
(3) On the first interlayer insulating film 5 including the metal thin-film resistance element 77, a CVD (chemical vapor deposition) oxide film 85 acting as an interlayer insulating film to provide insulation from a metal wiring is produced to have a film thickness of on the order of 2000 Å (see FIG. 26, (b)).
(3) On the CVD oxide film 85, a resist pattern 87, having an opening corresponding to both side parts of the metal thin-film resistance element 77, for producing connecting holes for metal wiring connections is produced. By means of wet etching technology, the CVD oxide film is partially removed repetitively with the use of the resist pattern 87 as a mask, and thus, the connecting holes 89 are formed (see FIG. 26, (c)).
   In a common process of manufacturing a semiconductor device, dry etching technology is applied for forming the connecting hole 89. However, for such a case where the metal thin-film resistance element 77 is so thin, i.e., less than 1000 Å, it is difficult to positively avoid the connecting holes 89 from passing through the metal thin-film resistance element 77. Therefore, in such a case, wet etching technology should be applied to form the connecting holes 89.
(4) On the CVD oxide film 85 including the connecting holes 89, a wiring metal film 91 made of an AlSiCu film is produced (see FIG. 26, (d)).
(5) On the wiring metal film 91, a resist pattern 93 for pattering the wiring metal film to leave it at both side parts of the metal thin-film resistance element 77 is produced (see FIG. 26, (e)).
(6) By means of dry etching technology, the wiring metal film 91 is patterned with the use of the resist pattern 93 as a mask, and a metal wiring pattern 95 (91) is produced. At this time, the CVD oxide film 85 is produced below the wiring metal film 91. As a result, it is possible to positively avoid the metal thin-film resistance element 77 from being etched even though dry etching technology is applied in this case.

By removing the resist pattern 93, production of the metal wiring patterns 95 (91) for making electrical connections from the metal thin-film resistance element 77 is completed (see FIG. 26, (f)).

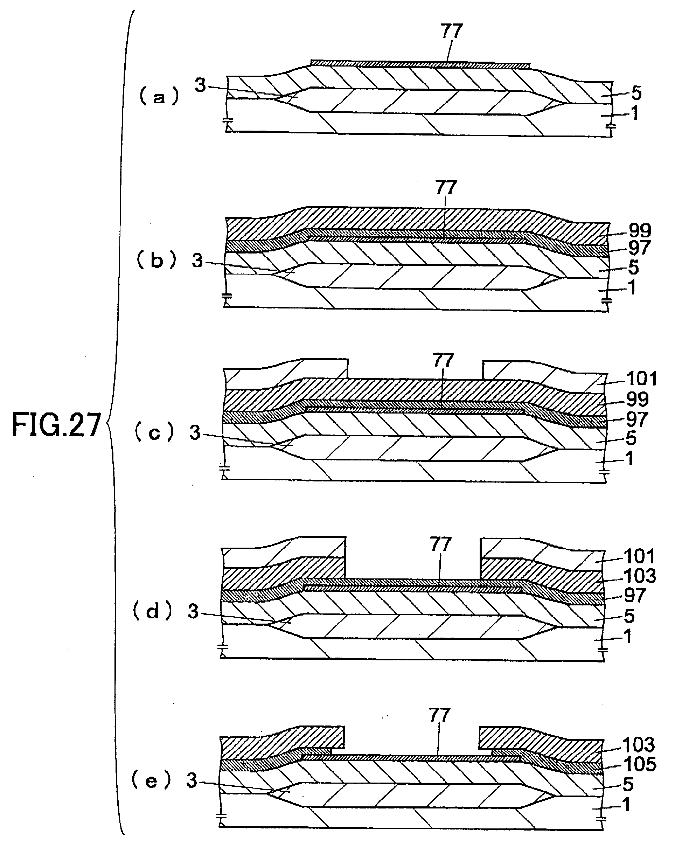

With reference to FIG. 27, the above-mentioned method 3) to produce a barrier film on the metal thin-film resistance element, and to connect a metal wiring to the barrier film, to make electrical connections from the metal thin-film resistance element is described next.
(1) In the same manner as that of the above-mentioned processes (1) through (3) with reference to FIG. 25, (a) through (c), the device separating oxide film 3, the first interlayer insulating film 5 and the metal thin-film resistance element 77 are produced on the silicon substrate 1 (see FIG. 27, (a)).
(2) On the interlayer insulating film 5 including the metal thin-film resistance element 77, a high-melting-point metal film 97 of TiW or such acting as a barrier film for a metal wiring is produced. Then, further thereon, a wiring metal film 99 made of an AlSi film, an AlSiCu film or such is produced (see FIG. 27, (b)).
(3) On the wiring metal film 99, a resist pattern 101 for pattering the wiring metal film 99 to leave it at both side parts of the metal thin-film resistance element 77 is produced (see FIG. 27, (c)).
(4) By means of dry etching technology, the wiring metal film 99 is patterned with the use of the resist pattern 101 as a mask, and thus, metal wiring patterns 103 are produced (see FIG. 27, (d)). At this time, the high-melting-point metal film 97 is thus produced below the wiring metal film 99. As a result, it is possible to avoid the metal thin-film resistance element 77 from being etched even though dry etching technology is thus applied in this case.

After removing the resist pattern 101, the high-malting-point metal film 97 is partially removed selectively with the use of the metal wiring pattern 103 as a mask by means of wet etching technology, and thus, high-melting-point metal film patterns 105 are produced. Thereby, production of the metal thin-film resistance element 77 and the metal wiring patterns 103 for making electrical connections from the metal thin-film resistance element 77 is completed (see FIG. 27, (e)). There, since the high-melting-point metal film 97 exists immediately above the metal thin-film resistance element 77, patterning of the high-melting-point metal film 97 by means of dry etching technology is difficult (see FIG. 27, (d)).

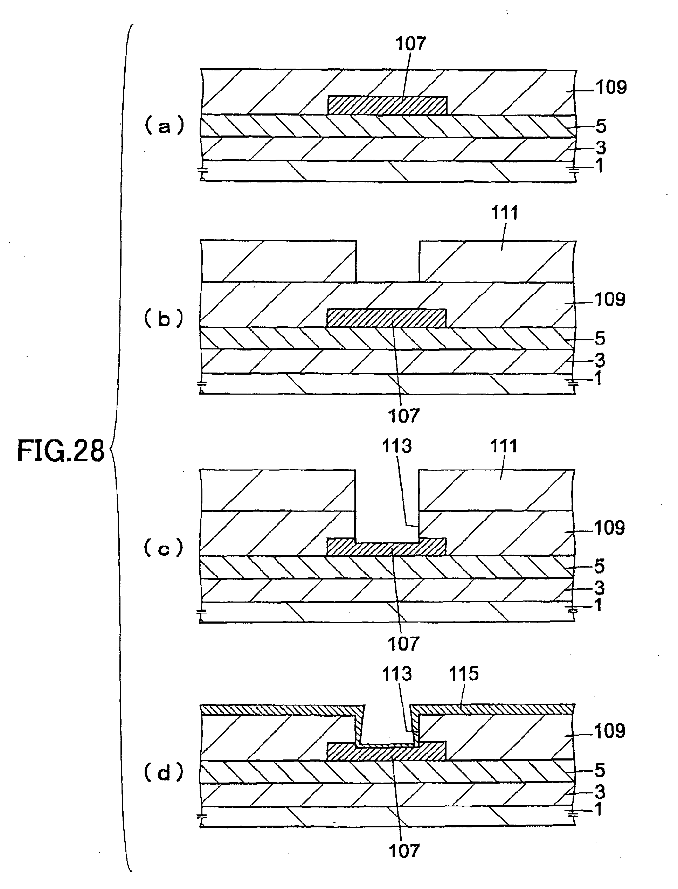

A semiconductor integrated circuit device is disclosed (for example, in the patent document 6, listed below, for example) having, not the metal thin-film resistance element, but a resistance element produced on a top layer wiring electrode via an insulating film, and connected with the top layer wiring electrode. A manufacturing method for a case where such a structure is applied to the metal thin-film resistance element is described next with reference to FIG. 28.
(1) On a wafer-shaped silicon substrate 1 for which production of a device separation oxide layer 3 and a transistor device or such (not shown) is already completed, a BPSG film acting as a first interlayer insulating film 5 between a gate electrode of the transistor and a metal wiring is produced, and reflow processing is carried out. After that, a metal wiring pattern 107 and a second interlayer insulating film 109 made of a CVD oxide film, an SOG (spin on glass) film and a CVD oxide film, in the stated order from the side of a lower layer, are produced (see FIG. 28, (a)). In FIG. 28, the lower layer side CVD oxide film, the SOG film and the upper layer side oxide film of the second interlayer insulating film 109 are shown as a unit.
(2) A resist pattern 111 for defining an area for producing a connecting hole is produced on the second interlayer insulating film 109 (see FIG. 28, (b)).
(3) By means of dry etching technology, the second interlayer insulating film 109 is partially removed selectively with the use of the resist pattern 111 as a mask, and thus, the connecting hole 113 is formed in the second interlayer insulating film 109 on the wiring pattern 107. At this time, an upper surface side part of the wiring pattern 107 is also removed by means of over-etching (see FIG. 28, (c)).
(4) After removing the resist pattern 111, a metal thin film 115 for producing the metal thin-film resistance element is produced on all the surface of the second interlayer insulating film 109 including the connecting hole 113 for a film thickness on the order of a range between 20 and 500 Å (see FIG. 28, (d)).

After that, the metal thin film 115 is patterned for a predetermined shape, and thus, the metal thin-film resistance element is produced therefrom.

Further, as a semiconductor device having the metal thin-film resistance element, an integrated circuit having the metal thin-film resistor mounted on an insulating film of a semiconductor integrated circuit is disclosed (for example, see the patent document 7 listed below) in which contact at an electrode part of the metal thin-film resistor between the metal thin-film resistor and a metal wiring is made at least at a part on an end surface and a top surface of the metal wiring.

The above-mentioned patent documents are listed now as follows:
the patent document 1: Japanese Laid-open Patent Application No. 2002-124639;
the patent document 2: Japanese Laid-open Patent Application No. 2002-261237;
the patent document 3: Japanese Patent No. 2699559;
the patent document 4: Japanese Patent No. 2932940;
the patent document 5: Japanese Patent No. 3185677;
the patent document 6: Japanese Laid-open Patent Application No. 58-148443;
the patent document 7: Japanese Laid-open Patent Application No. 61-100956.

In the above-mentioned method 1), as described above, the metal wiring pattern 83 is directly produced on the metal thin-film resistance element 77. However, in the process (5) described with reference to FIG. 25, (e), it is not possible to apply dry etching for carrying out pattering of the wiring metal film 79. Thus, it is not possible to produce a fine pattern, and thus, it may be difficult to achieve a highly integrated circuit.

Further, the metal thin-film resistance element 77 is easily oxidized in general, and, when the wiring metal film 79 is provided on the metal thin-film resistance element 77 after a surface thereof is oxidized, a satisfactory electrical connection between the metal thin-film resistance element 77 and the wiring metal film 79 may not be achieved. In a common semiconductor manufacturing process, a satisfactory electrical connection with a metal wiring may be achieved as a result of a natural oxide film on a surface of a silicon substrate being removed by means of hydrofluoric acid solution. However, since the metal thin-film resistance element 77 is etched by hydrofluoric acid for not a little amount, a resistance value of the metal thin-film resistance element 77 may vary if the oxide film removing processing with hydrofluoric acid is carried out before the wiring metal film 79 is produced in the above-mentioned process (4) described above with reference to FIG. 25, (d).

In the above-mentioned method 2), pattering of the wiring metal film 91 by means of dry etching technology is allowed in the process (6) described above with reference to FIG. 26, (f), as a result of the interlayer insulating film 85 being produced on the metal thin-film resistance element 77.

However, in the above-mentioned process (3) described with reference to FIG. 26, (c), it is necessary to apply wet etching to form the connecting holes 89 for connecting between the metal thin-film resistance element 77 and the metal wiring patterns 95 electrically, and thus, fine working may not be achieved. As a result, it may not be possible to achieve a highly integrated circuit. Furthermore hydrofluoric acid is applied in wet etching processing to form the connecting holes 89. In this process, in order to avoid the metal thin-film resistance element 77 from being etched by the hydrofluoric acid, it is necessary to carry out a countermeasure such as that to produce a barrier film on the metal thin-film resistance element 77 and to pattern it. Thus, an extra process should be added and thus, the number of manufacturing processes increases.

In the above-mentioned method 3), in the process (4) described above with reference to FIG. 27, (d), it is possible to apply dry etching in etching processing of the wiring metal film. Also, no connecting holes are required to be formed. However, in the process (5) described with reference to FIG. 27, (e), as described above, it is necessary to apply wet etching for patterning the high-melting-point metal film 97 for producing the high-melting-point metal film patterns 105 which substantially determine the length of the metal thin-film resistance element 77. Therefore, the high-melting-point metal film 97 may be etched wider than a desired etching area, the substantial length of the metal thin-film resistance element 77 may vary, and as a result, the resistance value may vary much. Also, a fine working may become difficult.

Furthermore, in the above-mentioned process (2) descried above with reference to FIG. 27, (b), a surface of the metal thin-film resistance element 77 which is produced in prior to the high-melting-point metal film 97 is oxidized. Accordingly, an oxide film on the surface of the metal thin-film resistance element 77 should be removed by hydrofluoric acid solution for the purpose of achieving a satisfactory electrical connection with the high-melting-point metal film 97. However, if the oxide film removing processing with hydrofluoric acid solution is carried out before the high-melting-point metal film 97 is produced, the resistance value of the metal thin-film resistance element 77 may vary.

Thus, in the conventional manufacturing methods, wet etching processing is required in some process by the reason that the film thickness of the metal thin-film resistance element is very small. As a result, fine working may be obstructed, or, variation in the resistance value may occur.

Furthermore, since the metal thin-film resistance element is easily oxidized, and if so, it is difficult to achieve a satisfactory electrical connection with the metal wiring, it is necessary to add a special process to produce a barrier film to protect the metal thin-film resistance element, or to carry out surface oxide film removing processing with the use of hydrofluoric acid, or such. Thus, the number of manufacturing processes increases or the resistance value may vary, accordingly.

Further, when a configuration disclosed by the above-mentioned patent document 6 having a resistance element produced on a top layer wiring electrode via an insulating film and connected with the top layer wiring electrode is applied to the metal thin-film resistance element, step coverage of the metal thin film 115 may degrade on an inner side surfaces of the connecting holes 113, in particular, on the side of the bottom of each connecting hole 113. As a result, the contact resistance between the metal thin-film resistance element and the wiring pattern 107 may increase and vary. Furthermore, due to variation of depth of the connecting holes in the surface of the wafer, diameters of the connecting holes or the step coverage of the metal thin film may vary, and further, the contact resistance may vary.

Furthermore, as shown in FIG. 28, (c), when the connecting holes 113 are produced, the second interlayer insulating film 109 is etched, and also, a part of the wiring pattern 107 on the top side is etched due to over-etching. For example, in a case where a mixture gas of Ar, CHF₃ and CF₄ is applied to the dry etching processing, and a main component of the wiring pattern 107 is Al, a product made of Al, C, F or such is produced when the wiring pattern 107 is etched during over-etching. Such a product may not be able to be completely removed in a post processing, and unevenness occurring due to the product may cause variation of the contact resistance between the metal thin-fill resistance element and the wiring patterns 107.

Further, in the configuration having the connecting holes for electrically connecting between the metal thin-film resistance element and the wiring patterns, the processes of pattering the resist with the use of photoengraving etching, production of the connecting holes with the use of dry etching technology, removal of the resist, removal of an etching reaction product from the inside of the connecting holes and so forth are required, and thus, the manufacturing method may become complicated.

Further, in the integrated circuit disclosed by the patent document 7, the electrode part of the metal thin-film resistance element is produced to cover the end surface and the top surface of the end part of the metal wiring. However, due to influence of steep step of the end surface of the metal wiring, the step coverage of the metal thin-film resistance element may degrade. As a result, the resistance value may increase, or breakage of the metal thin-film resistance element may occur.

An aim of the present invention is to achieve stabilization of a resistance value of the metal thin-film resistance element including a contact resistance with an electrode produced from a part of a wiring pattern in a semiconductor device having the metal thin-film resistance element and a method of manufacturing it.

According to a first mode of the present invention, a semiconductor device includes: an insulating film; a metal thin-film resistance element; a wiring pattern formed on the insulating film, a part of which forms an electrode for electrically connecting with the metal thin-film resistance element; and a side wall produced at least on a side surface of the electrode of the wiring pattern, and made of an insulation material, wherein: the metal thin-film resistance element is produced over from a top surface of the electrode through a surface of the insulating film across a surface of the side wall.

In this first mode of the semiconductor device according to the present invention, a second side wall including Ar may be produced on a surface of the side wall on the side of the insulating film. The second side wall including Ar may be produced by carrying out Ar sputter etching processing (which may also be called inverse sputtering processing) after producing the wiring pattern and the side wall.

According to a second mode of the present invention, a semiconductor device includes: a first insulating film; a metal thin-film resistance element; a wiring pattern formed on the first insulating film; and a second insulating film on the first insulating film with a film thickness such that a top surface of the wiring pattern may be exposed, wherein: the metal thin-film resistance element is produced over from a top surface of the electrode through a surface of the second insulating film.

In any of the above-described first and second modes of the semiconductor devices according to the present invention, a part of the metal thin-film resistance element may intersect the wiring pattern on the electrode.

The above-mentioned 'a part of the metal thin-film resistance element may intersect the wiring pattern on the electrode' means that, according to the first mode of the present invention, a part of the metal thin-film resistance element is produced over a surface of the side wall produced on one side of the electrode through a surface of the other side wall produced on the opposite side of the electrode across the top surface of the electrode. In the second mode of the present invention, a part of the metal thin-film resistance element is produced over from a surface of the second insulating film produced in the vicinity of one side of the electrode through a surface of the other second insulating film produced in the vicinity of the opposite side of the electrode across the top surface of the electrode.

In any of the above-described first and second modes of the present invention, a film thickness of the metal thin-film resistance element may be, for example, in a range between 5 and 1000 Å, or more preferably, in a range between 20 and 500 Å.

In any of the above-described first and second modes of the present invention, the wiring pattern may be made of a metal material pattern and a high-melting-point metal film produced at least on a top surface of the metal material pattern.

In any of the above-described first and second modes of the present invention, the wiring pattern may be made of a polysilicon pattern and a high-melting-point metal film produced at least on a top surface of the polysilicon pattern.

In any of the above-described first and second modes of the present invention, a metal nitride film covering a top surface of the metal thin-film resistance element may be produced, wherein: no metal oxide film is produced between a top surface of the metal thin-film resistance element and the metal nitride film.

In any of the above-described first and second modes of the present invention, the wiring pattern may correspond to a wiring pattern of a top layer.

In one example of the semiconductor device according to the present invention, a semiconductor device includes a dividing resistance circuit in which a voltage output is obtained as a result of a voltage being divided by means of a plurality of resistance elements, and the voltage output is adjustable as a result of a fuse element being brown out, wherein: the resistance elements are made of the metal thin-film resistance elements according to the present invention.

In another example of the semiconductor device according to the present invention, a semiconductor device includes a voltage detecting circuit including: a dividing resistance circuit for supplying a divided voltage as a result of dividing an input voltage; a reference voltage generating circuit for supplying a reference voltage; and a comparison circuit for comparing between the divided voltage from the dividing resistance circuit and the reference voltage from the reference voltage generating circuit, wherein: the dividing resistance circuit includes the metal thin-film resistance elements included in the semiconductor device according to the present invention as a resistance element.

In another example of the semiconductor device according to the present invention, a semiconductor device includes a constant voltage generating circuit including: an output driver controlling an output of an input voltage; a dividing resistance circuit for supplying a divided voltage as a result of dividing the output voltage; a reference voltage generating circuit for supplying a reference voltage; and a comparison circuit for comparing between the divided voltage from the dividing resistance circuit and the reference voltage from the reference voltage generating circuit, and controlling the output driver according to a comparison result, wherein: the dividing resistance circuit includes the metal thin-film resistance elements included in the semiconductor device according to the present invention as resistance elements.

A semiconductor device manufacturing method according to a first aspect of the present invention for manufacturing a semiconductor device including a metal thin-film resistance element and an insulating film includes:
(A) wiring pattern producing step of producing a wiring pattern on the insulating film, a part of the wiring pattern including an electrode providing electrical connection with the metal thin-film resistance element;
(B) side wall producing step of producing an insulating material layer on the insulating film including an area in which the wiring pattern is thus produced, and then, carrying out etch back processing on the insulating material layer and producing therefrom a side wall on a side surface of the wiring pattern:
(C) metal thin film producing step of producing a meta thin film on the insulating film including an area in which the wiring pattern and the side wall are thus produced,; and
(D) patterning step of patterning the metal thin film to leave it over from the top surface of the electrode through the insulating film across a surface of the side wall, so as to produce the metal thin-film resistance element.

A semiconductor device manufacturing method according to a second aspect of the present invention for manufacturing a semiconductor device including a metal thin-film resistance element and a first insulating film includes:
(A) wiring pattern producing step of producing a wiring pattern on the first insulating film, a part of the wiring pattern including an electrode providing electrical connection with the metal thin-film resistance element;
(B) second insulating film producing step of producing a second insulating film on the first insulating film with a film thickness such that a top surface of the wiring pattern may be exposed;
(C) metal thin film producing step of producing a metal thin film on the wiring pattern and the second insulating film; and
(D) patterning step of patterning the metal thin film so as to leave it over from a top surface of the electrode through the second insulating film, so as to produce the metal thin-film resistance element.

In any of the above-described methods in the first and second aspects of the present invention, in the metal thin film producing step (C), the metal thin film produced should have a film thickness in a range between 5 and 1000 Å, more preferably, in a range between 20 and 500 Å, for example.

In any of the above-described methods in the first and second aspects of the present invention, in the metal thin film producing step (C), before producing the metal thin film, Ar sputter etching processing may be carried out.

Further, the Ar sputter etching processing may be carried out to a film thickness corresponding to a thermally-oxidized film etching amount of equal to or more than 25 Å, for example.

In any of the above-described methods in the first and second aspects of the present invention, in the wiring pattern producing step (A), as the wiring pattern, one made of a metal material pattern and a high-melting-point metal film produced at least on a top surface of the metal material pattern may be applied.

In any of the above-described methods in the first and second aspects of the present invention, in the wiring pattern producing step (A), as the wiring pattern, one made from a polysilicon pattern and a high-melting-point metal film produced at least on a top surface of the polysilicon pattern may be applied.

Further, the high-melting-point metal film produced should have a metal thickness in a range between 500 and 3000 Å, for example.

In any of the above-described methods in the first and second aspects of the present invention, in the metal thin film producing step (C), a metal nitride film may be produced continuously on the metal thin film in an oxygen free atmosphere after the metal thin film is produced in the oxygen free atmosphere; and in the pattering step (D), the metal nitride film and the metal thin film may be patterned so that a laminated pattern made of the metal nitride film pattern and the meal thin-film resistance element may be produced.

Further, a nitride partial pressure in a sputtering gas when the metal nitride film is produced is in a range between 18 and 90 %, for example.

In any of the above-described methods in the first and second aspects of the present invention, the wiring pattern is applied as a wiring pattern in a top layer, for example.

A first configuration of a semiconductor device according to the present invention includes: an insulating film; a metal thin-film resistance element; a wiring pattern formed on the insulating film, a part of which forms an electrode for electrically connecting with the metal thin-film resistance element; and a side wall produced at least on a side surface of the electrode of the wiring pattern, and made of an insulation material, wherein: the metal thin-film resistance element is produced over from a top surface of the electrode through a surface of the insulating film across a surface of the side wall. As a result, it is not necessary to carry out patterning by way of wet etching technology after the metal thin-film resistance element is produced. Further, since a contact surface of the metal thin-film resistance element with the wiring pattern is not exposed to the atmospheric air, it is possible to obtain a satisfactory electrical connection between the metal thin-film resistance element and the wiring pattern even without carrying out surface oxide film removing processing or producing an etching preventing barrier. Accordingly, it is possible to achieve miniaturization of the metal thin-film resistance element and stabilization of the resistance value thereof without regard to the film thickness of the metal thin-film resistance element without increasing the number of manufacturing processes.

Furthermore, since the metal thin-film resistance element is produced over from the top surface of the electrode made of a part of the wiring pattern through the insulating film across the surface of the side wall, it is not necessary to produce the above-mentioned connecting holes produced above-mentioned the wiring pattern through which electrical connection is made between the metal thin-film resistance element and the wiring pattern. As a result, it is not necessary to carry out a series of manufacturing processes for producing the connecting holes, and thus it is possible to shorten and simplify the manufacturing processes. Also, a variation of the resistance value and increase of the contact resistance with the electrode otherwise occurring due to degradation of step coverage of the metal thin-film resistance element caused by the provision of the connecting holes may be avoided.

Further, since the side wall is produced on the side surface of the wiring pattern, degradation of step coverage of the metal thin-film resistance element otherwise occurring due to steep step at the side surface of the wiring pattern may also be avoided.

Thus, according to the first configuration of the semiconductor device according to the present invention, it is possible to achieve stabilization of the resistance value of the metal thin-film resistance element including the contact resistance with the electrode.

In a second configuration of the present invention, in the above-described first configuration of the present invention, a second side wall including Ar is produced on a surface of the side wall on the side of the insulating film. The second side wall is produced as a result of Ar sputter etching processing being carried out after the wiring pattern and the first side wall are produced. Conventionally, the metal thin-film resistance element may be affected by the foundation film, that is, the resistance value may vary due to a composition of the foundation film or due to an elapse of time from production of the foundation film. By Appling the above-mentioned second configuration of the present invention, it is possible to reduce dependency of the sheet resistance of the metal thin-film resistance element from the foundation film and to reduce deterioration due to aging, and thus, it is possible to achieve stabilization of the resistance value of the metal thin-film resistance element. The effects obtained from carrying out Ar sputter etching processing on the foundation film of the metal thin-film resistance element will be described later.

A third configuration of a semiconductor device according to the present invention includes: a first insulating film; a metal thin-film resistance element; a wiring pattern formed on the first insulating film; and a second insulating film on the first insulating film with a film thickness such that a top surface of the wiring pattern may be exposed, wherein: the metal thin-film resistance element is produced over from a top surface of the electrode through a surface of the second insulating film.

Accordingly, the same as in the above-mentioned first configuration of the semiconductor device, it is not necessary to carry out patterning by way of wet etching technology after the metal thin-film resistance element is produced. Further, since a contact surface of the metal thin-film resistance element with the wiring pattern is not exposed to the atmospheric air, it is possible to achieve miniaturization of the metal thin-film resistance element and stabilization of the resistance value thereof without regard to the film thickness of the metal thin-film resistance element without increasing the number of manufacturing processes.

Furthermore, since the metal thin-film resistance element is produced over from the top surface of the electrode made of a part of the wiring pattern through the second insulating film, the same as in the first configuration, it is not necessary to produce the above-mentioned connecting holes produced above-mentioned the wiring pattern through which electrical connection is made between the metal thin-film resistance element and the wiring pattern. As a result, it is possible to shorten and simplify the manufacturing processes in comparison to the case where the connecting holes are produced. Also, a variation of the resistance value and increase of the contact resistance with the electrode may be avoided.

Further, since the second insulating film is produced on the side surface of the wiring pattern, degradation of step coverage of the metal thin-film resistance element otherwise occurring due to steep step at the side surface of the wiring pattern may also be avoided.

Thus, according to the third configuration of the semiconductor device according to the present invention, it is possible to achieve stabilization of the resistance value of the metal thin-film resistance element including the contact resistance with the electrode.

According to a semiconductor device in a fourth configuration according to the present invention, a part of the metal thin-film resistance element intersects the wiring pattern on the electrode. Accordingly, it is possible to reduce variation of a contact area between the electrode and the metal thin-film resistance element otherwise occurring due to a misalignment between the wiring pattern and the metal thin-film resistance element or rounding of the metal thin-film resistance element at an end part thereof, and thus, it is possible to further stabilize the resistance value.

According to a semiconductor device according to a fifth configuration according to the present invention, a film thickness of the metal thin-film resistance element is in a range between 5 through 1000 Å, more preferably, in a range between 20 and 500 Å. As described above, according to the present invention, it is not necessary to apply wet etching technology for patterning after producing the metal thin-film resistance element and further the contact surface of the metal thin-film resistance element with the wiring pattern is not exposed to the atmospheric air. Accordingly, it is possible to obtain satisfactory electrical connection between the metal thin-film resistance element and the wiring pattern even without carrying out surface oxide film removing processing or production of an etching preventing barrier for the metal thin-film resistance element. Further, it is possible to improve step coverage of the metal thin-film resistance element in the vicinity of the electrode. Accordingly, even when the present invention is applied to a semiconductor device having the metal thin-film resistance element with such a large film thickness, it is possible to achieve miniaturization and stabilization of the resistance value of the metal thin-film resistance element.

According to a semiconductor device according to a sixth configuration of the present invention, the wiring pattern is made of a metal material pattern and a high-melting-point metal film produced at least on a top surface of the metal material pattern. Accordingly, it is possible to insert the high-melting-point metal film between the metal thin-film resistance element and the metal material pattern of the wiring pattern without increase the number of manufacturing processes. Thus, it is possible to reduce variation of the contact resistance of the metal thin-film resistance element with the wiring pattern, and thus, it is possible to improve accuracy of the resistance and the yield. Further, the contact resistance may change much due to thermal processing even at a relatively low temperature such as 300 through 400 °C in a structure in which the metal thin-film resistance element directly contacts the metal wiring. However, in the sixth configuration of the present invention in which the wiring pattern is made of the metal material pattern and the high-melting-point metal film, since the high-melting-point metal film is inserted between the metal thin-film resistance element and the metal material pattern, such a problem may be solved. Further, even for a case where the high-melting-point metal film is produced only on a top surface of the metal material pattern, since the side wall made of insulating material is produced on a side surface of the wiring pattern, i.e., on a side surface of the metal material pattern, no contact is made between the metal thin-film resistance element and a side surface of the metal material pattern as in the above-mentioned patent document 7, and thus, it is possible to avoid variation of the contact resistance between the metal thin-film resistance and the wiring pattern otherwise occurring due to the thermal processing.

In a semiconductor device according to a seventh configuration of the present invention, the wiring pattern is made of a polysilicon pattern and a high-melting-point metal film produced at least on a top surface of the polysilicon pattern. Accordingly, it is possible to insert the high-melting-point metal film between the metal thin-film resistance element and the polysilicon pattern of the wiring pattern without increasing the number of manufacturing processes. Thereby, it is possible to reduce variation of the resistance value between the metal thin-film resistance element and the wiring pattern, and it is possible to improve stabilization of the resistance value of the metal thin-film resistance element and the accuracy thereof.

In a semiconductor device according to an eighth configuration of the present invention, a metal nitride film covering a top surface of the metal thin-film resistance element is provided, wherein: no metal oxide film is produced between a top surface of the metal thin-film resistance element and the metal nitride film. Thereby, it is possible to avoid oxidization of the top surface of the metal thin-film resistance element, and thus, it is possible to improve stabilization of the resistance value of the metal thin-film resistance element and also, to improve the accuracy of the same.

In a semiconductor device according to a ninth configuration of the present invention, the wiring pattern corresponds to a wiring pattern of a top layer. As a result, it is possible to increase design freedom, for example, layout change of the metal thin-film resistance element can be achieved by layout change of the metal thin-film resistance element and the top layer wiring pattern.

Further, by disposing the metal thin-film resistance element on an insulating film produced on the top layer wiring pattern, a final protection film made of an insulating material is produced. Thus, it is possible to reduce the film thickness of the insulating material on the metal thin-film resistance element, and to reduce film thickness variation, in comparison to a case where another insulating film is produced on the metal thin-film resistance element in addition to the protection film. As a result, when carrying out trimming processing by applying a laser beam to the metal thin-film resistance element, it is possible to reduce variation of laser interference in the insulating film on the metal thin-film resistance element and to reduce laser energy variation applied to the metal thin-film resistance element. Thus, it is possible to improve accuracy of the trimming. Further, it is possible to improve radiation capability with respect to a temperature rise in the metal thin-film resistance element caused by laser beam application in the trimming processing.

In a semiconductor device according to a tenth configuration of the present invention, the semiconductor device includes: a dividing resistance circuit in which a voltage output is obtained as a result of a voltage being divided by means of a plurality of resistance elements, and the voltage output is adjustable as a result of a fuse element being brown out, wherein: the resistance elements are made of the metal thin-film resistance elements included in the semiconductor device according to the present invention. In this configuration, it is possible to achieve miniaturization of the resistance elements and stabilization of the resistance value by applying the metal thin-film resistance element included in the semiconductor devise according to the present invention. Thus, it is possible to reduce a required area for producing the dividing resistance circuit and improve accuracy of the output voltage.

In a semiconductor device according to an eleventh configuration of the present invention, the semiconductor device includes a voltage detecting circuit which includes: a dividing resistance circuit for supplying a divided voltage as a result of dividing an input voltage; a reference voltage generating circuit for supplying a reference voltage; and a comparison circuit for comparing between the divided voltage from the dividing resistance circuit and the reference voltage from the reference voltage generating circuit, wherein: the dividing resistance circuit is made of the dividing resistance circuit according to the above-mentioned tenth configuration of the present invention. In this configuration, by applying the resistance elements included in the semiconductor device according to the present invention to the dividing resistance circuit, it is possible to reduce a required area for producing the dividing resistance circuit and to improve accuracy of the output voltage. Thus, it is possible to reduce a required area for producing the voltage detecting circuit and to improve the accuracy of voltage detection performance.

In a semiconductor device according to a twelfth configuration of the present invention, the semiconductor device includes a constant voltage generating circuit including: an output driver controlling an output of an input voltage; a dividing resistance circuit for supplying a divided voltage as a result of dividing the output voltage; a reference voltage generating circuit for supplying a reference voltage; and a comparison circuit for comparing between the divided voltage from the dividing resistance circuit and the reference voltage from the reference voltage generating circuit, and controlling the output driver according to a comparison result, wherein: the dividing resistance circuit is made of the dividing resistance circuit according to the tenth configuration of the present invention. In this configuration, by applying the resistance elements included in the semiconductor device according to the present invention to the dividing resistance circuit, it is possible to reduce a required area for producing the dividing resistance circuit and to improve accuracy of the output voltage. Thus, it is possible to reduce a required area for producing the constant voltage generating circuit and to improve stabilization of the output voltage.

A semiconductor device manufacturing method for manufacturing a semiconductor device including a metal thin-film resistance element and an insulating film according to a thirteenth configuration of the present invention includes:
(A) wiring pattern producing step of producing a wiring pattern on the insulating film, a part of the wiring pattern including an electrode providing electrical connection with the metal thin-film resistance element;
(B) side wall producing step of producing an insulating material layer on the insulating film including an area in which the wiring pattern is produced, and then, carrying out etch back processing on the insulating material layer and producing a side wall on a side surface of the wiring pattern:
(C) metal thin film producing step of producing a meta thin film on the insulating film including an area in which the wiring pattern and the side wall are produced; and
(D) patterning step of patterning the metal thin film to leave it across from a top surface of the electrode through the insulating film across a surface of the side wall so as to produce the metal thin-film resistance element.

As a result, it is not necessary to carry out patterning by way of wet etching technology after the metal thin-film resistance element is produced. Further, since a contact surface of the metal thin-film resistance element with the wiring pattern is not exposed to the atmospheric air, it is possible to obtain a satisfactory electrical connection between the metal thin-film resistance element and the wiring pattern even without carrying out surface oxide film removing processing or producing an etching preventing barrier. Accordingly, it is possible to achieve miniaturization of the metal thin-film resistance element and stabilization of the resistance value without regard to the film thickness of the metal thin-film resistance element without increasing the number of manufacturing processes.

Furthermore, since the metal thin film producing step (C) and patterning step (D) are carried out in which the metal thin-film resistance element is produced over from the top surface of the electrode made of a part of the wiring pattern and through insulating film across the surface of the side wall, it is not necessary to produce the above-mentioned connecting holes produced above the wiring pattern through which electrical connection is made between the metal thin-film resistance element and the wiring pattern. As a result, it is not necessary to carry out a series of manufacturing processes for producing the connecting holes, and thus it is possible to shorten and simplify the processes. Also, variation of the resistance value and increase of the contact resistance with the electrode otherwise occurring due to degradation of step coverage of the metal thin-film resistance element caused by the provision of the connecting holes may be avoided accordingly.

Further, since the side wall producing step (B) is carried out in which the side wall is produced on the side surface of the wiring pattern, degradation of step coverage of the metal thin-film resistance element otherwise occurring due to a steep step at the side surface of the wiring pattern may also be avoided.

Thus, according to the semiconductor device manufacturing method according to the thirteenth configuration of the present invention, it is possible to achieve stabilization of the resistance value of the metal thin-film resistance element including the contact resistance with the electrode.

A semiconductor device manufacturing method according to a fourteenth configuration of the present invention for manufacturing a semiconductor device including a metal thin-film resistance element and a first insulating film includes:
(A) wiring pattern producing step of producing a wiring pattern on the first insulating film, a part of the wiring pattern including an electrode providing electrical connection with the metal thin-film resistance element;
(B) second insulating film producing step of producing a second insulating film on the first insulating film with a film thickness such that a top surface of the wiring pattern is exposed;
(C) metal thin film producing step of producing a metal thin film on the wiring pattern and the second insulating film; and
(D) patterning step of patterning the metal thin film to leave it over from a top surface of the electrode through the second insulating film, so as to produce the metal thin-film resistance element.

Accordingly, the same as in the above-mentioned thirteenth configuration of the semiconductor device manufacturing method, it is not necessary to carry out patterning by way of wet etching technology after the metal thin-film resistance element is produced. Further, since a contact surface of the metal thin-film resistance element with the wiring pattern is not exposed to the atmospheric air, it is possible to achieve miniaturization of the metal thin-film resistance element and stabilization of the resistance value without regard to the film thickness of the metal thin-film resistance element without increasing the number of manufacturing processes.

Furthermore, since the metal thin film producing step (C) and the patterning step (D) are carried out in which the metal thin-film resistance element is produced over from the top surface of the electrode made of a part of the wiring pattern through the second insulating film, the same as in the thirteenth configuration it is not necessary to produce the above-mentioned connecting holes otherwise produced above the wiring pattern through which electrical connection is made between the metal thin-film resistance element and the wiring pattern. As a result, it is possible to shorten and simplify the processes in comparison to the case where the connecting holes are produced. Also, variation of the resistance value and increase of the contact resistance with the electrode may be avoided.

Further, since the second insulating film producing step (B) is carried out in which the second insulating film is produced on the side surface of the wiring pattern, degradation of step coverage of the metal thin-film resistance element otherwise occurring due to the steep step at the side surface of the wiring pattern may also be avoided.

Thus, according to the semiconductor device manufacturing method according to the fourteenth configuration of the present invention, it is possible to achieve stabilization of the resistance value of the metal thin-film resistance element including the contact resistance with the electrodes.

In a semiconductor device manufacturing method according to a fifteenth configuration of the present invention, in the above-mentioned metal thin film producing step (C), the metal thin film produced has a film thickness in a range between 5 and 1000 Å, more preferably, between 20 and 500 Å. As described above, according to the present invention, it is not necessary to apply wet etching technology for patterning after producing the metal thin-film resistance element and further the contact surface of the metal thin-film resistance element with the wiring patter is not exposed to the atmospheric air. Accordingly, it is possible to obtain satisfactory electrical connection between the metal thin-film resistance element and the wiring pattern even without carrying out surface oxide film removing processing or production of etching preventing barrier for the metal thin-film resistance element. Further, it is possible to improve step coverage of the metal thin-film resistance element in the vicinity of the electrode. Accordingly, even when the present invention is applied to a semiconductor device having the metal thin-film resistance element with such a large film thickness, it is possible to achieve miniaturization and stabilization of the resistance value of the metal thin-film resistance element.

In a semiconductor device manufacturing method according to a sixteenth configuration of the present invention, in the metal thin film producing step (C), before producing the metal thin film, Ar sputter etching processing is carried out. As described above, the resistance value of the metal thin-film resistance element may be affected by the foundation film. However, by carrying out Ar sputter etching processing, it is possible to reduce dependency of the sheet resistance of the metal thin-film resistance element from the foundation film and to reduce deterioration due to aging, and thus, it is possible to achieve stabilization of the resistance value of the metal thin-film resistance element. The effects obtained from carrying out Ar sputter etching processing on the foundation film of the metal thin-film resistance element will be described later.

In a semiconductor device manufacturing method according to a seventeenth configuration of the present invention, in the above-mentioned wiring pattern producing step (A), the wiring pattern is made of a metal material pattern and a high-melting-point metal film produced at least on a top surface of the metal material pattern. Accordingly, it is possible to thus insert the high-melting-point metal film between the metal thin-film resistance element and the metal material pattern of the wiring pattern without increase of the number of manufacturing processes. Thus, it is possible to reduce variation of the contact resistance of the metal thin-film resistance element with the wiring pattern, and thus, it is possible to improve accuracy of the resistance and the yield. Further, the contact resistance may change much due to thermal processing even at a relatively low temperature such as 300 through 400 °C in a structure in which the metal thin-film resistance element directly contacts the metal wiring. However, as a result of inserting the high-melting-point metal film being inserted between the metal thin-film resistance element and the wiring pattern, such a problem may be solved.

In a semiconductor device manufacturing method according to an eighteenth configuration of the present invention, in the above-mentioned wiring pattern producing step (A), the wiring pattern includes a polysilicon pattern and a high-melting-point metal film produced at least on a top surface of the polysilicon pattern. Accordingly, it is possible to thus insert the high-melting-point metal film between the metal thin-film resistance element and the polysilicon pattern of the wiring pattern without increasing the number of manufacturing processes. Thereby, it is possible to reduce variation of the contact resistance value between the metal thin-film resistance element and the wiring pattern, and thus, it is possible to improve the accuracy of the resistance value and the yield.

In a semiconductor device manufacturing method according to a nineteenth configuration of the present invention, the above-mentioned high-melting-point metal film produced has a metal thickness in a range between 500 and 3000 Å. Thereby, it is possible to finally leave the high-melting-point metal film of a sufficient film thickness on the top surface of the wiring pattern even for a case where a process of carrying out Ar sputter etching is carried out before producing the above-mentioned metal thin film in the metal thin film producing step (C).

In a semiconductor device manufacturing method according to a twentieth configuration of the present invention, in the metal thin film producing step (C), a metal nitride film is produced continuously on the metal thin film in an oxygen free atmosphere continuously after the metal thin film is produced in the oxygen free atmosphere; and in the pattering step (D), the metal nitride film and the metal thin film are patterned so that a laminated pattern including the metal nitride film pattern and the meal thin-film resistance element is produced. Thereby, it is possible to avoid oxidization of the top surface of the metal thin-film resistance element, and thus, it is possible to stabilize the resistance value of the metal thin-film resistance element and to improve the accuracy thereof.

In a semiconductor device manufacturing method according to a twenty-first configuration of the present invention, the wiring pattern corresponds to a wiring pattern in a top layer. As a result, it is possible to increase design freedom, for example, it is possible to achieve layout change of the metal thin-film resistance element by layout change of the metal thin-film resistance element and the top layer wiring pattern.

Further, by disposing the metal thin-film resistance element on an insulating film produced on the top layer wiring pattern, a final protection film made of an insulating material is then produced. Thus, it is possible to reduce the film thickness of the insulating material produced on the metal thin-film resistance element, and to reduce film thickness variation, in comparison to a case where another insulating film is produced on the metal thin-film resistance element in addition to the above-mentioned protection film. As a result, when carrying out trimming processing by applying a laser beam to the metal thin-film resistance element, it is possible to reduce variation of laser interference in the insulating film above the metal thin-film resistance element and to reduce laser energy variation applied to the metal thin-film resistance element. Thus, it is possible to improve accuracy of the trimming. Further, it is possible to improve radiation capability with respect to temperature rise in the metal thin-film resistance element caused by laser beam application in the trimming processing.

Other objects and further features of the present invention will become more apparent from the following detailed description of exemplary embodiments and the accompanying drawings, in which:
FIG. 1 shows an area in which a metal thin-film resistance element according to a first embodiment of a first mode according to the present invention is produced, (A) showing a plan view; (B) showing a front elevational sectional view taken along a A-A line of (A); and (C) showing a magnified view of a part defined by a broken line in (B);
FIG. 2 shows process sectional view for illustrating one embodiment of a first aspect of a manufacturing method according to the present invention;
FIG. 3 shows a relationship between a sheet resistance of a metal thin-film resistance element produced according to the present invention, the ordinate axis denoting the sheet resistance (Ω/□) and the abscissa axis denoting CrSi film thickens (Å);
FIG. 4 shows relationship between a value (σ /AVE) obtained from dividing a standard deviation (σ) obtained from measurement of sheet resistance values at 62 positions within a wafer by an average (AVE) and a film thickness, the ordinate axis denoting σ/AVE (%), the abscissa axis denoting CrSi film thickness (Ω/□);
FIG. 5 shows relationship between the sheet resistance of CrSi thin-film resistance element when Ar sputter etching is carried out or is not carried out before a metal thin film for a metal thin-film resistance element is produced, and a time elapsing after a foundation film of the metal thin-film resistance element is produced, (A) showing the case of carrying out the processing while (B) showing the case of not carrying out the processing, the ordinate axis denoting the sheet resistance (Ω/□) and the abscissa axis denoting a time elapsing after the foundation film is produced;
FIG. 6 shows relationship between an amount of Ar sputter etching and the sheet resistance, the ordinate axis denoting the sheet resistance (Ω/□) and the abscissa axis denoting the etching amount (in a thermally oxidized film etching amount) (Å);
FIG. 7 shows relationship between a time for which a product is left in the atmospheric air of temperature of 25 °C and humidity of 45% after a CrSi thin film for a metal thin-film resistance element is produced, and a change rate (ΔR/R0) of the sheet resistance from the same measured immediately after the production, the ordinate axis denoting ΔR/R0 (%) and the abscissa axis denting a time of leaving;
FIG. 8 shows a result of studying a variation of contact resistance between a metal thin-film resistance and a metal wiring due to thermal processing for a sample for which high-melting-point metal film is left at a bottom part of a connecting hole upon production of the connecting hole and a sample for which the high-melting-point metal film is removed, the ordinate axis denoting the contact resistance value normalized by the same measured before thermal processing and the abscissa axis denoting the number of times of thermal processing carried out;
FIG. 9 shows an area in which a metal thin-film resistance element according to a second embodiment of the first mode according to the present invention is produced, (A) showing a plan view; (B) showing a front elevational sectional view taken along a B-B line of (A); and (C) showing a magnified view of a part defined by a broken line in (B);
FIG. 10 shows relationship between an N₂ partial pressure in gas for producing a CrSiN film, and resistivity of CrSiN film, the ordinate axis denoting resistivity ρ (mohm • cm) and the abscissa denoting N₂ partial pressure (%);
FIG. 11 shows an area in which a metal thin-film resistance element according to a first embodiment of a second mode according to the present invention is produced, (A) showing a plan view; (B) showing a front elevational sectional view taken along a C-C line of (A); and (C) showing a magnified view of a part defined by a broken line in (B);
FIG. 12 shows a process sectional view for illustrating a first embodiment of a second aspect of a manufacturing method according to the present invention;
FIG. 13 shows an area in which a metal thin-film resistance element according to a second embodiment of the second mode according to the present invention is produced, (A) showing a plan view; (B) showing a front elevational sectional view taken along a D-D line of (A); and (C) showing a magnified view of a part defined by a broken line in (B);
FIG. 14 shows an area in which a metal thin-film resistance element according to a third embodiment of the first mode according to the present invention is produced, (A) showing a plan view; (B) showing a front elevational sectional view taken along a E-E line of (A); and (C) showing a magnified view of a part defined by a broken line in (B);
FIG. 15 shows a process sectional view for illustrating a second embodiment of the first aspect of a manufacturing method according to the present invention;
FIG. 16 shows an area in which a metal thin-film resistance element according to a third embodiment of the second mode according to the present invention is produced, (A) showing a plan view; (B) showing a front elevational sectional view taken along a F-F line of (A); and (C) showing a magnified view of a part defined by a broken line in (B);
FIG. 17 shows a manufacturing method according to a second embodiment of the second aspect of the present invention;
FIGS. 18 and 19 show plan views of areas in which metal thin-film resistance elements according to other embodiments of the present invention, respectively;
FIG. 20 shows a circuit diagram of one embodiment of a semiconductor device having a constant voltage generating circuit which is an analog circuit;
FIG. 21 shows a circuit diagram of one embodiment of a semiconductor device having a voltage detecting circuit which is an analog circuit;
FIG. 22 shows a circuit diagram of one embodiment of a semiconductor device having a dividing resistance circuit which is an analog circuit;
FIG. 23 is a layout diagram showing a layout example of a fuse element part of the dividing resistance circuit;
FIG. 24 is a layout diagram showing a layout example of a metal thin-film resistance element part of the dividing resistance circuit;
FIG. 25 shows a process sectional view for illustrating one example of a manufacturing method according to the prior art;
FIG. 26 shows a process sectional view for illustrating another example of a manufacturing method according to the prior art; and
FIG. 27 shows a process sectional view for illustrating further another example of a manufacturing method according to the prior art;
FIG. 28 shows a process sectional view for illustrating further another example of a manufacturing to the prior art.

### DESCRIPTION OF THE PREFERRED EMBODIMENTS

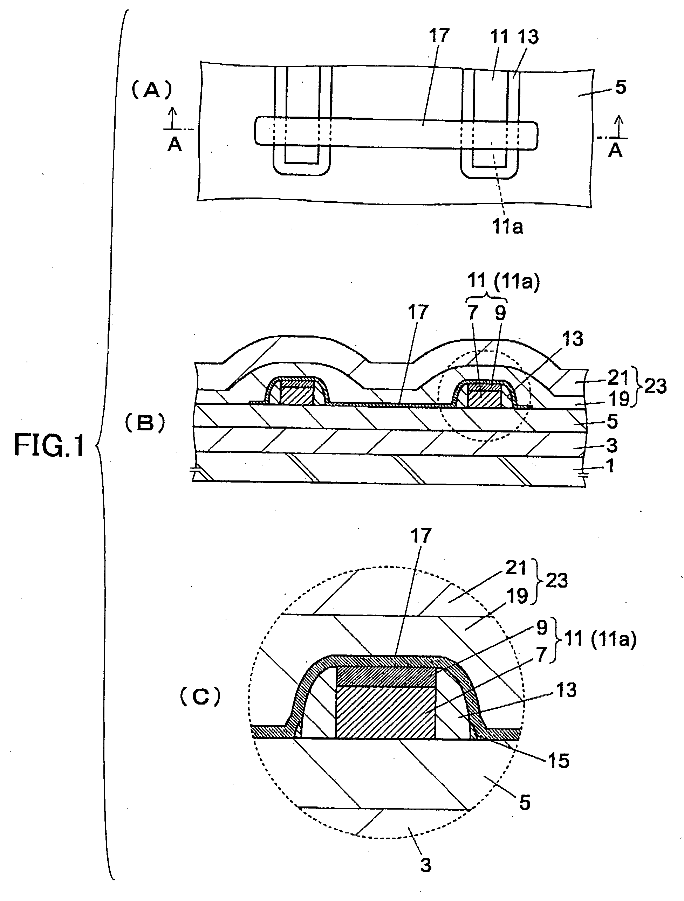

FIG. 1 shows an area of producing a metal thin-film resistance element according to a first embodiment of a first mode of the present invention, (A) showing a plan view; (B) showing a front elevational sectional view taken along a A-A line of (A); and (C) showing a magnified view of a part defined by a broken line in (B). In FIG. 1, (A), a passivation film is omitted. In this embodiment described below, on a common substrate, a transistor device, a capacitance device or such is produced, but is omitted in the figures.

On a silicon substrate 1, a device separating oxide film 3 is produced. An interlayer insulating film 5 made of a BPSG film or a PSG (phosphor silicate glass) is produced on the silicon substrate 1 including an area having the device separating film 3. On the interlayer insulating film 5, a wiring pattern 11 made of a metal material pattern 7 and a high-melting-point metal film 9 produced on a surface of the metal material pattern 7 is produced. The metal material pattern 7 is made of, for example, an AlSiCu film. The high-melting-point metal film 9 is made of, for example, a TiN film, and acts as a reflection preventing film and also as a barrier film.

On side surfaces of the wiring pattern 11, side walls 13 made of insulating material, for example, CVD oxide films are produced. Second side walls 15 (omitted in FIG. 1, (A) and (B)) are produced on surfaces of the side walls 13 on the side of the interlayer insulating film 5. The second side walls 15 are produced as a result of Ar sputter etching being carried out on the interlayer insulating film 5 after the wiring pattern 11 and the side walls 13 are produced The second side walls 15 include Ar as a component, and further include materials of the interlayer insulating film 5, the side walls 13 and the high-melting-point metal film 9

On surfaces of the side walls 13, surfaces of the side walls 13 and the interlayer insulating film 5 between a pair of the opposing wiring patterns 11, a belt-shaped CrSi thin-film resistance element (metal thin-film resistance element) 17 is produced. Both end parts of the CrSi thin-film resistance element 17 extend to the surfaces of the side walls 13 and the second walls 15, produced on side surfaces of the pair of the wiring patterns 11 on the side opposite to the side surfaces opposing between the pair of wiring pattern 11, and also extend to the interlayer insulating film 5, as shown. The CrSi thin-film resistance element 17 and the wiring patterns 11 intersect each other as shown in FIG. 1, (A). Parts at which the wiring patterns 11 are intersected by the CrSi thin-film resistance element 17 form electrodes 11a.

The passivation film (omitted in FIG. 1, (A)) is produced on the interlayer insulating film 5 including the area having the CrSi thin-film resistance element 17, and is made of a silicon oxide film 19 on the bottom layer side and a silicon nitride film 21 on the upper layer side.

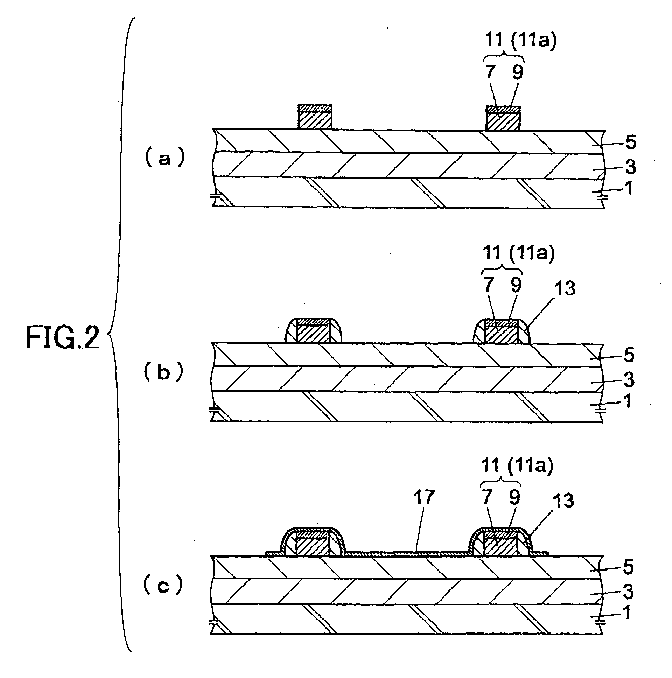

FIG. 2 shows a process sectional view for illustrating one embodiment of a first aspect of a manufacturing method according to the present invention. This embodiment is applied to manufacture the embodiment of semiconductor device described above with reference to FIG. 1. With reference to FIGS. 1 and 2, the present embodiment of the manufacturing method is described now.
(1) For example, with the use of a normal pressure CVD apparatus, the interlayer insulating film 5 made of a BPSG film or a PSG film is produced for a film thickness of approximately 8000 Å on the wafer-shaped silicon substrate 1 on which production of the device separating oxide film 3 and the transistor device or such (not shown) is completed. After that, thermal processing such as reflow is carried out, and thus, a surface of the interlayer insulating film 5 is planarized.
   For example, with the use of a DC magnetron sputtering apparatus, a wiring metal film made of an AlSiCu film is produced for a film thickness of 5000 Å on the interlayer insulating film 5, and further thereon, a high-melting-point metal film, i.e., a TiN film in this case, used as a reflection preventing film which is in a well-known technology is produced continuously in a vacuum for a film thickness of 500 Å. The high-melting-point metal film finally acts as a barrier film for stabilizing a contact resistance between the metal material pattern made of the wiring metal film at a subsequent process and the metal thin-film resistance element. Accordingly, it is preferable to produce both the wiring metal film and the high-melting-point metal film continuously in vacuo.
   By means of well-known photoengraving technology and etching technology, the high-melting-point metal film and the wiring metal film are patterned, and thus, the wiring pattern 11 made of the metal wiring pattern 7 and the high-melting-point metal film 9 is produced (see FIG. 2, (a)). At this time, on the wiring metal film, the high-melting-point metal film acting as the reflection preventing film is produced. Thereby, it is possible to control a variation of an area of a resist pattern used for defining the area of producing the wiring pattern 11 to the minimum.
   At this stage, the metal thin-film resistance element is not yet produced unlike in the prior art, and the foundation film of the wiring pattern 11 is made of the interlayer insulating film 5. Accordingly, it is possible to carry out the patterning of the high-melting-point metal film and the wiring metal film by means of dry etching technology for a sufficient over-etching amount. As a result, there is no necessity to apply pattering by means of wet etching as in the prior art, and thus, miniaturization of a circuit is not affected.
(2) With the use of a plasma CVD process for example, a plasma CVD oxide film is produced for a film thickness of on the order of 2000 Å on the interlayer insulating film 5 including the area having the wiring pattern 11. After that, etch back processing is carried out, and thus, the side walls 13 (see FIG. 2, (b)) made of the plasma CVD oxide film are produced on the side surfaces of the wiring pattern 11.
(3) For example, in an Ar sputter etching chamber of a multi-chamber sputtering apparatus, in vacuo, Ar sputter etching processing is carried out on the interlayer insulating film 5 including the area having the wiring pattern 11 and the side walls 13b in a condition of DC bias: 1250 V; Ar: 20 sccm; pressure: 8.5 milliTorrs; and processing time: 20 seconds. This etching condition is equivalent to an etching condition to carry out etching of a thermally oxidized film produced in a wet atmosphere of 1000 °C by approximately 50 Å. A film thickness of the high-melting-point metal film 9 after this processing was carried out was on the order of 400 Å. By means of the Ar sputter etching processing, second side walls 15 (see FIG. 1, (C)) made of an Ar sputter etching residual and including Ar as a component are produced on surfaces of the side walls 13 on the sides of the interlayer insulating film 5 as shown in FIG. 1, (C).
   Then, the CrSi thin film (metal thin film) for the metal thin-film resistance element is produced continuously without breakage of the vacuum state after the completion of the Ar sputter etching. There, after moving the semiconductor wafer from the Ar sputter etching chamber into a sputtering chamber in which a CrSi target was loaded, processing was carried out with the use of the CrSi target of Si/Cr = 80/20 wt% (weight percents), in a condition of DC power: 0.7 kW; Ar: 85 sccm; pressure: 8.5 milliTorrs; processing time: 9 seconds. Thus, the CrSi thin film was produced for a film thickness of approximately 50 Å on all the surface of the interlayer insulating film 5 including the areas having the wiring patterns 11 and the side walls 13 and 15.
   By means of photoengraving technology, a resist pattern for defining the area of producing the metal thin-film resistance element on the CrSi thin film is produced. For example, with the use of an RIE (reaction ion etching) apparatus, using the resist pattern as a mask, the CrSi thin film is patterned, and thus, the CrSi thin-film resistance element 17 is produced (see FIG. 2, (c)). After that, the above-mentioned resist pattern is removed. There, since the CrSi thin-film resistance element 17 is already electrically connected with the electrodes 11a which are parts of the wiring patterns 11, it is not necessary to carry out processing of removing a metal oxide film from a surface of the CrSi thin-film resistance element 17 with hydrofluoric solution for making electrical connection on the top surface of the metal thin-film resistance element as in he prior art.
(4) For example, by means of a plasma CVD process, a silicon oxide film 19 and a silicon nitride film 21 as a passivation film are produced in sequence on all the surface of the interlayer insulating film 5. Thus, the semiconductor device manufacturing process is completed (see FIG. 1).

In the embodiment of the semiconductor device described with reference to FIG. 1 and the manufacturing method described with reference to FIGS. 1 and 2 above, it is not necessary to carry out patterning by wet etching technology after production of the CrSi thin-film resistance element 17. Further, the contact surface of the CrSi thin-film resistance element 17 with each wiring pattern 11 is not exposed to the atmospheric air. Accordingly, even without carry out surface oxide film removing processing for the CrSi thin-film resistance element 17 nor production of etching preventing barrier film, it is possible to obtain sufficient electrical connection between the CrSi thin-film resistance element 17 and the wiring pattern 17 stably. Thereby, without regard to the film thickness of the CrSi thin-film resistance element 17, it is possible to achieve miniaturization and stabilization of the resistance value of the CrSi thin-film resistance element 17 without increasing the number of manufacturing processes required.

Further, since the CrSi thin-film resistance element 17 is produced over from the top surface of the electrode 11a made of a part of each wiring pattern 11 through the interlayer insulating film 5 via the surfaces of the side walls 13 and 15, it is not necessary to carry out the series of processing to produce the connecting holes which would be carried out in the case where the connecting holes were produced to make electrical connection between the metal thin-film resistance element and the wiring patterns. Accordingly, it is possible to shorten and simplify the manufacturing process. Also, variation of the resistance value of the metal thin-film resistance element and increase of the contact resistance with the electrode do not occur which would otherwise occur due to degradation of step coverage of the metal thin-film resistance element occurring due to existence of the connecting holes.

Further, since the side walls 13 are produced on the side surfaces of the wiring pattern 11, degradation of step coverage of the CrSi thin-film resistance element 17 otherwise occurring due to steep steps at the side surfaces of the wiring pattern can be avoided.

Thus it is possible to achieve stabilization of the resistance value of the CrSi thin-film resistance element 17 including the contact resistance with each electrode 11a.

Further, since both end parts of the CrSi thin-film resistance element 17 extend to intersect the wiring patterns 11 on the electrodes 11a, it is possible to avoid variation of contact areas between the electrodes 11a and the CrSi thin-film resistance element 17 otherwise occurring due to misalignment between the wiring patterns 11 and the CrSi thin-film resistance element 17 or rounding of end parts of the CrSi thin-film resistance element 17. Thus, it is possible to obtain the further stabilized contact resistances.

Further, since the high-melting-point metal film 9 acting as the barrier film is inserted between the CrSi thin-film resistance element 17 and the metal material pattern 7, it is possible to reduce variation of the contact resistance between the CrSi thin-film resistance element 17 and the wiring pattern 11, and thus, it is possible to improve accuracy of the resistance value and the yield.

Furthermore, since the high-melting-point metal film 9 also acts as the reflection preventing film is provided, and also, it is possible to produce the high-melting-point metal film 9 without increasing the number of manufacture processes in comparison to the prior art, it is possible to stabilize the contact resistance between the metal thin-film resistance element and the wiring pattern while preventing increase of the manufacturing cost.

Further, as a result of carrying out the Ar sputter etching processing as mentioned above, it is possible to remove insulating substance from the top surface of the high-melting-point metal film 9 of the wiring pattern 11, and also, it is possible to improve foundation film dependence of the CrSi thin-film resistance element 17 produced in a subsequent process. This effect is described next.

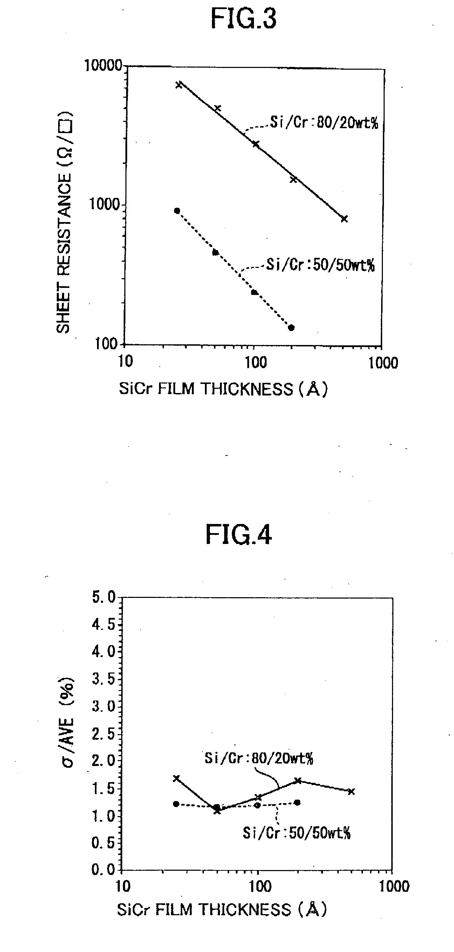

With reference to FIGS. 3 and 4, a result of studying characteristics of the metal thin-film resistance element produced in the same configuration as the above-mentioned embodiment is described. FIG. 3 shows relationship between a sheet resistance of the metal thin-film resistance element and a film thickness thereof, the ordinate axis denoting the sheet resistance (Ω/□) and the abscissa axis denoting the CrSi film thickness (Å). FIG. 4 shows relationship between a value (σ /AVE) obtained from dividing a standard deviation (σ) of measurement results of the sheet resistance at 63 positions within the wafer surface of the metal thin-film resistance element by an average thereof (AVE), and the CrSi film thickness, the ordinate axis denoting σ/AVE and the abscissa axis denoting the CrSi film thickness (Å). There, as a sample, a structure in which the metal thin-film resistance element and the wiring patterns are electrically connected via the connecting holes produced in the insulating film on the wiring pattern was applied.

A condition of producing the thin-film resistance element is as follows:

A multi-chamber sputtering apparatus was used, DC power: 0.7 kW; Ar: 85 sccm; pressure: 8.5 milliTorrs; target: two types, i.e., Si/Cr = 50/50 wt% or 80/20 wt%. Then, by adjusting a volume time, samples with CrSi film thicknesses in a range between 25 and 500 Å were produced. It is noted that, for the samples of Si/Cr = 50/50 wt%, one in a film thickness of 500 Å was not produced.

Further, Ar sputter etching processing before production of the CrSi thin film was carried out with the use of the above-mentioned multi-chamber sputtering apparatus; in a condition of DC bias: 1250 V; Ar: 20 sccm; pressure: 8.5 milliTorrs; processing time: 160 seconds. This is equivalent to a condition for etching and removing 400 Å of a thermally oxidized film produced in a wet atmosphere at 1000 °C. Further, for each sample, a structure was applied in which, as a metal wiring of a bottom layer to connect the metal thin-film resistance element, an AlSiCu film of a film thickness of 5000 Å was used, and a TiN film was not produced on the AlSiCu film at a bottom part of each connecting hole between the AlSiCu film and the CrSi thin film.

The measurement of the sheet resistance was carried out by a two terminal method in which, twenty belt-shaped patterns each having a width of 0.5 µm and a length of 50 µm were arranged with intervals of 0.5 µm each, and a current value was measured upon applying a voltage of 1V across one metal thin-film resistance element thereof.

Further, a plan size of each connecting hole connecting between the metal wiring and the CrSi thin-film resistance element was 0.6 µm by 0.6 µm.

As shown in FIG. 3, it can be seen that, without regard to the composition of the target (Si/Cr = 50/50 wt% or Si/Cr = 80/20 wt%), from the film thickness of equal to or more than 200 Å through a very thin film thickness of 25 Å, a linearity between the film thickness and the sheet resistance is maintained, and thus, it is possible to produce the metal thin-film resistance element in a miniaturized size with a thin film thickness, which cannot be achieved in the prior art.

Further, as shown in FIG. 4 showing a variation in the sheet resistance in 63 positions within the wafer surface, it can be seen that, the variation in the sheet resistance is hardly affected by the film thickness for both two types of targets (Si/Cr = 50/50 wt% and Si/Cr = 80/20 wt%), the variation itself is very small and thus, the sheet resistance is stable. Therefrom, it is said that, by applying the structure according to the present invention, it is possible to produce a much miniaturized metal thin-film resistance element pattern without regard to the film thickness of the metal thin-film resistance element.

It can be expected that, the effect obtained from the Ar sputter etching before production of the CrSi thin film is obtained in the same way, not only from a structure in which the metal thin-film resistance element and the wiring pattern are electrically connected via the connecting holes produced in the insulating film on the wiring pattern but also from a structure in which, as in the semiconductor according to the present invention, the wiring pattern and the metal thin-film resistance element are electrically connected on the electrodes made of parts of the wiring patterns.

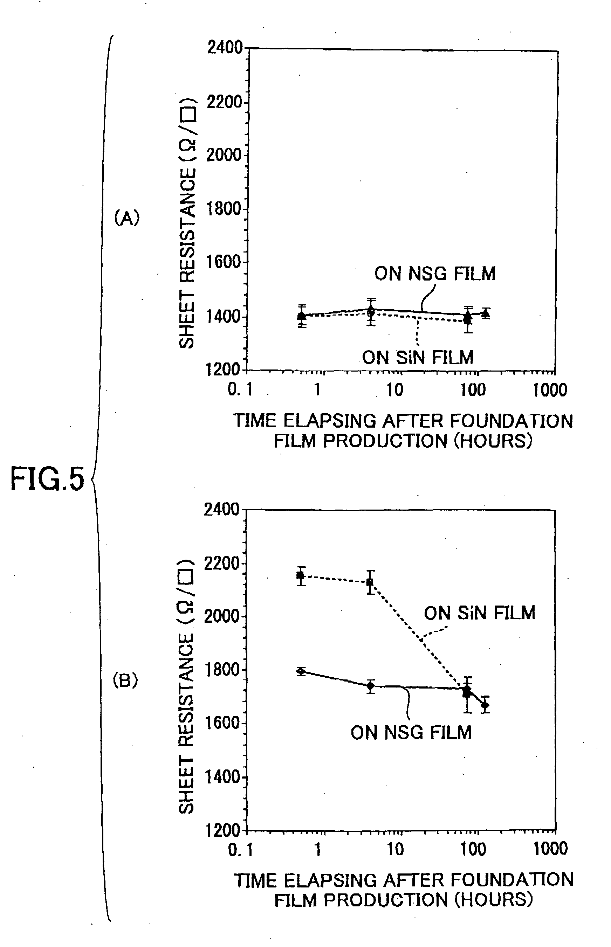

FIG. 5 shows relationship between the sheet resistance of the CrSi thin-film resistance element both for a case where Ar sputter etching processing was carried out before the metal thin film for the metal thin-film resistance element was produced and for a case where the Ar sputter etching was not carried out, and a time having elapsed after the foundation film of the metal thin-film resistance element was produced. FIG. 5, (A) shows the case where the processing was carried out while (B) shows a case where the processing was not carried out. The ordinate axis denotes the sheet resistance (Ω/□) and the abscissa axis denotes the time having elapsed after the production of the foundation film (hours).

As samples for the results of FIG. 5, two different types of silicon wafers, as the foundation film, i.e., a plasma SiN film produced for a film thickness of 2000 Å by a plasma CVD process; and a plasma NSG (non-doped silicate glass) film, were prepared. Then with the use of the CrSi thin-film resistance element produced on each of these silicon wafers, the sheet resistance of the CrSi thin-film resistance element was measured by a four terminal method.

The plasma SiN film as the foundation film was produced with the use of a parallel plane plate type plasma CVD apparatus, in a condition of temperature: 360 °C; pressure: 5.5 Torrs; RF power: 200 W; SiH₄: 70 sccm; N₂: 3500 sccm; NH₃: 40 sccm.

The plasma NSG film was produced with the use of a parallel plane plate type plasma CVD apparatus, in a condition of temperature: 400 °C; pressure: 3.0 Torrs; RF power: 250 W; SiH₄: 16 sccm; N₂O: 1000 sccm.

The CrSi thin-film resistance element was produced for a film thickness of 100 Å as a result of processing being carried out with the use of a multi-chamber sputtering apparatus in a condition of target: Si/Cr = 80/20 wt%; DC power: 0.7 kW; Ar: 85 sccm; pressure: 8.5 milliTorrs; and volume time: 13 seconds.

Ar sputter etching was carried out with the use of the above-mentioned multi-chamber sputtering apparatus, in a condition of DC bias: 1250 V; Ar: 20 sccm; pressure: 8.5 milliTorrs; processing time: 80 seconds. This condition is equivalent to a condition for etching and removing 200 Å of a thermally oxidized film produced in a wet atmosphere at 1000 °C.

As shown in FIG. 5, (B), in the case where Ar sputter etching processing was not carried out before production of the CrSi thin film, it is seen that the sheet resistance differs much according to a difference in the type of the foundation film (i.e., the SiN film or the NSG film). Furthermore, it is affected much by the time having elapsed before production of the CrSi thin-film resistance element after production of the foundation film.

In contrast thereto, as shown in FIG. 5, (A), in the case where the Ar sputter etching was carried out, the sheet resistance of the CrSi thin-film resistance element was hardly affected by the type of the function film or the elapsing time.

Therefrom, it is seen that, by carrying out production of the metal thin film for the metal thin-film resistance element continuously in vacuo after carrying out Ar sputter etching, it is possible to much reduce a variation of the resistance value otherwise occurring due to a time having elapsed from a previous process, a difference of the foundation film which differs for each particular product, or such.

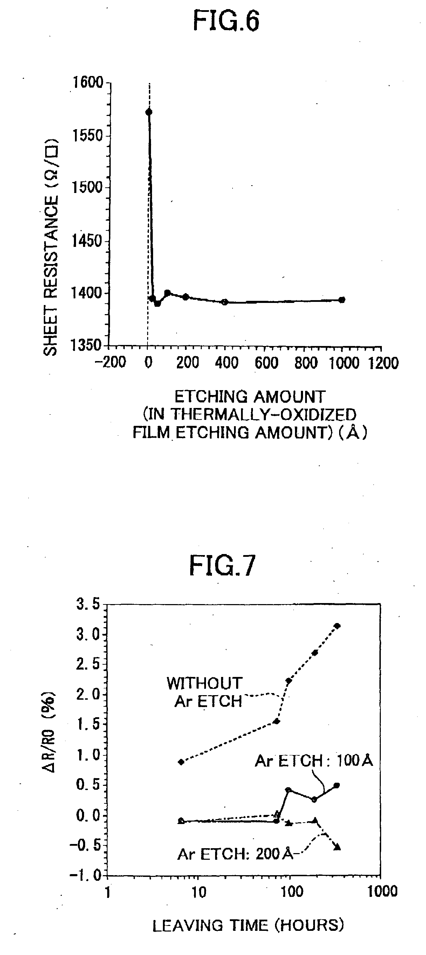

FIG. 6 shows relationship between an amount of Ar sputter etching and the sheet resistance. The ordinate axis denotes the sheet resistance (Ω/□), and the abscissa axis denotes the etching amount (expressed by a value translated in a thermally oxidized film etching amount) (Å). As to each sample for the result of FIG. 6, as the foundation film and the CrSi thin-film resistance element, the plasma NSG film and the CrSi thin-film resistance element produced in the same manner as that for the samples of the results of FIG. 5 were applied. Further, in this case, Ar sputter etching was carried out on the plasma NSG film having elapsed one week after the film production, and after that, the CrSi thin-film resistance element was produced on the NSG film. A condition of the Ar sputter etching was the same as that for the samples of FIG. 5 other than the etching amount. Then, adjustment was made for 0 Å (Ar sputter etching was not carried out); 25 Å; 50 Å; 100 Å; 200 Å; 400 Å; and 1000 Å in a value translated in an etching amount of a thermally oxidized film produced in wet atmosphere. The sheet resistance of the CrSi thin-film resistance element was measured by a four terminal method.

From the results of FIG. 6, it can be seen that, it is possible to obtain the effect of resistance value stabilization for the CrSi thin-film resistance element by carrying out Ar sputter etching only for an amount equivalent to a film thickness equal to or more than 25 Å in a thermally oxidized film etching amount produced in wet atmosphere. In FIG. 6, the samples include only those etched for the film thickness of 1000 Å in a value translated in a thermally oxidized film etching amount as the Ar sputter etching condition. However, it is expected that the above-mentioned Ar sputter etching effect may be obtained also for a case where etching is carried out for an amount equivalent to more than 1000 Å in a thermally oxidized film etching amount, as long as the foundation film still remains in the area to produce the metal thin-film resistance element.

Further, it has been seen that the effect of Ar sputter etching effect affects not only on influence of the foundation film but also on stabilization of the resistance value itself of the CrSi thin film.

FIG. 7 shows relationship between a time for which, after the CrSi thin film was produced, the sample was left in an atmosphere of temperature: 25 °C and humidity: 45%, and a change ratio (ΔR/R0) of the sheet resistance with respect to the value (R0) measured immediately after the film production. The ordinate axis denotes ΔR/R0 and the abscissa axis denotes the leaving time (hours).

As to samples of FIG. 7, the plasma NSG film and the CrSi thin-film resistance element produced in the same condition as that for the sample preparation for FIG. 5 were applied.

As to a condition of Ar sputter etching, three types were prepared, i.e., samples for which no processing was carried out (without Ar etch); those for which the processing was carried out in a condition: thermally oxidized film etching amount equivalent value: 100 Å; and processing time of 40 seconds (Ar etch: 100 Å); and those for which the processing was carried out in a condition: a thermally oxidized film etching amount equivalent value; 200 Å; and processing time of 80 seconds (Ar etch: 200 Å).

As to the samples for which Ar sputter etching was not carried out (without Ar etch), the resistance value decreased from the film production as a time elapsed, and, after 300 hours has elapsed, the resistance value varied for more than 3 %.

In contrast thereto, for the samples for which Ar sputter etching was carried out (Ar etch: 100 Å and Ar etch: 200 Å), the change rate of the resistance value greatly decreased, and, even after more than 300 hours has elapsed, the resistance value did not deviate from the sheet resistance immediately after the film production by more than ±1 %.

Further, in comparison between the Ar etch: 100 Å and Ar etch: 200 Å, it has been seen that, influence of the etching amount is small, and the effect can be obtained even by a slight amount of etching.

With reference to FIGS. 3 through 7, the advantages of the present invention have been described in terms of influence of the foundation film for the sheet resistance, and influence of atmosphere leaving time. However, these advantages are not limited to the CrSi thin-film of the target of Si/Cr = 50/50 wt% or 80/20 wt% which was applied as the samples, but the same advantages were observed for all the CrSi thin films and CrSiN thin films produced with the use of the targets of Si/Cr = 50/50 through 90/10 wt%.

Furthermore, the Ar sputter etching method is not limited to the DC bias sputter etching method applied currently.

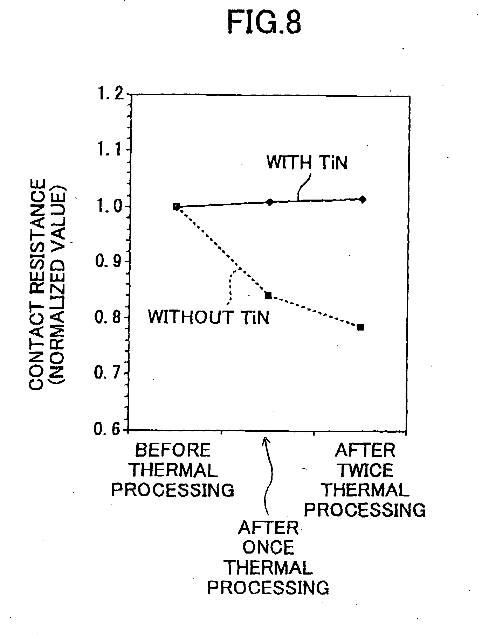

FIG. 8 shows relationship between variation of the contact resistance between the metal thin-film resistance element and the metal wiring occurring due to thermal processing. The ordinate axis denotes a value notarized by the contact resistance value before undergoing thermal processing, and the abscissa axis denotes the number of times of thermal processing. There, as each sample, a structure was applied in which, via the connecting holes produced in the insulating film on the wiring pattern, the metal thin-film resistance element and the wiring pattern are electrically connected. Further, variation in the contact resistance was studied for samples for which the high-melting-point metal film was left at a bottom part of the connecting holes upon the connecting hole production and those for which the same was completely removed.

As the samples for FIG. 8, those for which the high-melting-point metal film was left on the order of the film thickness of 500 Å at the bottom part of the connecting holes were produced by adjustment of dry etching duration upon connecting hole production, and those for which the same was completely removed were produced.

As the high-melting-point film, a TiN film was applied.

The CrSi thin-film resistance element was produced for a film thickness of 50 Å in a condition of Si/Cr = 80/20 wt%; DC power: 0.7 kW; Ar: 85 sccm; pressure: 8.5 milliTorrs; and volume time: 6 seconds.

The Ar sputter etching processing before production of the CrSi thin film was carried out in a condition of: DC bias: 1250 V; Ar: 20 sccm; pressure: 8.5 milliTorrs; processing time: 160 seconds. This processing corresponding to that for etching and removing 400 Å of thermally oxidized film produced in wet atmosphere at 1000 °C.

A plan size of each connecting hole was 0.6 µm by 0.6 µm. A four terminal method was applied for measuring the contact resistance.

Study was made as to how the contact resistance varies as a result of thermal processing of 30 minutes in nitrogen atmosphere at 350 °C being additionally carried out.

For the samples for each of which the TiN film was left at the bottom part of the connecting hole (with TiN), the contact resistance hardly changed, even after the thermal procession was carried out twice, from that before the thermal processing. In contrast thereto, for the samples (without TiN) for each of which the TiN film was completely removed, the contact resistance varied by more than 20 % as a result of the twice of the thermal processing being additionally carried out, with respect to that before the thermal processing. This means that, the TiN film acts as a barrier film for preventing resistance variation otherwise occurring due to interaction between the CrSi thin film and the metal wiring.

By inserting the TiN film between the CrSi thin-film resistance element and the metal wiring, it is possible to much reduce resistance variation otherwise occurring due to thermal processing such as sintering, CVD or such carried out during a manufacturing process, and also, it is possible to reduce resistance variation otherwise occurring due to thermal processing such as soldering carried out during an assembly process which is a post processing. Thereby, it is possible to stably obtain a set resistance, and also, it is possible to avoid variation of the contact resistance occurring before or after the assembly. Thus, it is possible to increase the accuracy of the product and also to increase the yield.

It is expected that, the advantages obtained from inserting the TiN film between the CrSi thin-film resistance element and the metal wiring are obtainable not only from the structure in which the metal thin-film resistance element and the metal wiring are eclectically connected via the connecting holes produced in the insulating film on the wiring pattern but also from a structure in which, as in the semiconductor according to the present invention, the wiring patterns and the metal thin-film resistance element are electrically connected on the electrodes made of parts of the wiring patterns, in the same manner.

In the embodiment of the manufacturing method described above with reference to FIGS. 1 and 2, Ar sputter etching processing is carried out immediately before production of the CrSi thin film in the above-mentioned process (3). However, the high-melting-point metal film 9 made of the TiN film does not have a natural oxide film produced thereto not so stiff as that of AlSiCu film even if it is exposed to the atmospheric air. Accordingly, it is possible to obtain an electrical connection between the CrSi thin film and the wiring pattern 11 even without carrying out Ar sputter etching processing. In this case, no side walls 15 are produced. However, as described above, since carrying out of Ar sputter etching immaterially before production of the CrSi thin film can improve stability of the resistance value of the CrSi thin-film resistance element 17, it is still preferable to carry out Ar sputter etching also in this case.

Further, in the above-mentioned embodiment, the CrSi thin-film resistance element 17 is produced on the interlayer insulating film 5 made of the BPSG film or the PSG film. However, the present invention is not limited to this foundation film used as a foundation of the metal thin-film resistance element. As an insulating film applied as a foundation of the metal thin-film resistance element, another insulating film may be applied, for example, an insulating film having undergone planarization with the use of a CMP (chemical mechanical polish) technology which is a well-known technology, an insulating film having undergone planarization as result of coating of an SOG film, etch back or such, a plasma CVD oxide film not having undergone planarization, or such. However, many analog resistance devices are used in such a situation that not only TCR but also pair characteristics, specific accuracy or such should be managed as essential characteristics. Therefore, for a case where the metal thin-film resistance element included in the semiconductor device according to the present invention is applied as an analog resistance device, it is preferable that the insulating film applied as a foundation of the metal thin-film resistance element has undergone planarization.

Further, in the above-mentioned embodiment, the passivation film 23 is provided on the CrSi thin-film resistance element 17. However, the present invention is not limited to such a structure, and, any insulating film may be applied as a film provided on the CrSi thin-film resistance element 17, for example, an interlayer insulating film for producing metal wiring for a second layer may be applied.

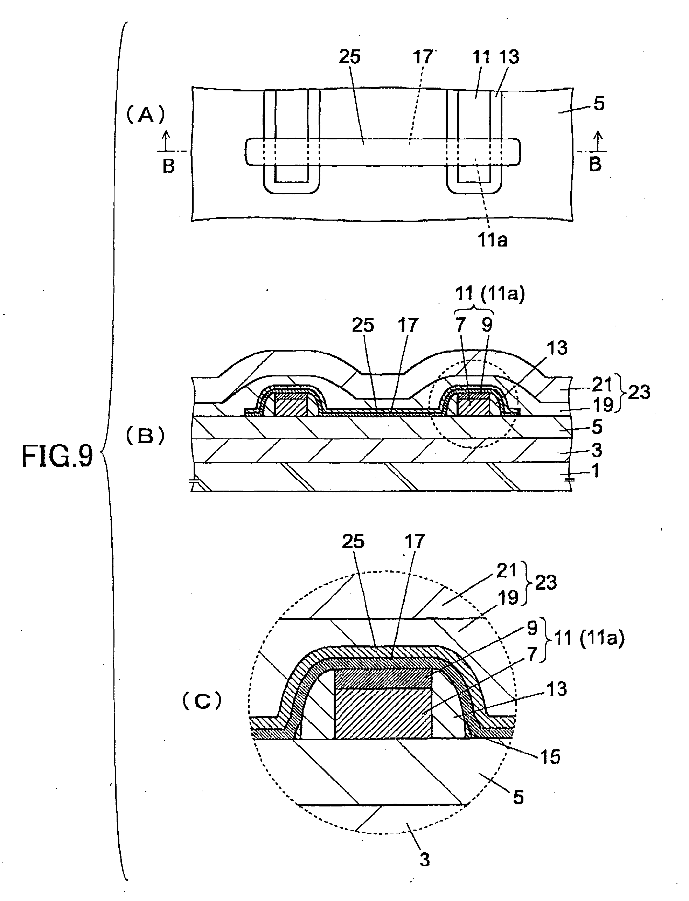

FIG. 9 shows an area having a metal thin-film resistance element in a second embodiment of the first mode of the semiconductor device according to the present invention. FIG. 9, (A) shows a plan view; FIG. 9, (B) shows a sectional view taken along a B-B position of FIG. 9, (A); and FIG. 9, (C) shows a magnified view of a portion defined by broken line in FIG. 9, (B).. In FIG. 9, (A), a passivation film is omitted. The same reference numerals are given to parts having the same functions as those in FIG. 1, and detail description thereof is omitted.

On a silicon substrate 1, a device separating oxide film 3, an interlayer insulating film 5, wiring patterns 11 made of metal material patterns 7 and high-melting-point metal films 9, side walls 13 and second side walls 15 are produced.

A CrSi thin-film resistance element 17 is produced to intersect a pair of wiring patterns 11 on electrodes 11a, and extend through the interlayer insulating film 5, across the surfaces of the electrodes 11a and the surfaces of the side walls 13 and 15. On the top surface of the CrSi thin-film resistance element 17, a CrSiN film (metal nitride film) 25 is produced. CrSiO is not produced between the CrSi thin-film resistance element 17 and the CrSiN film 25.

A passivation film 23 made of a silicon oxide film 19 and a silicon nitride film 21 is produced on all the surface of the interlayer insulating film 5.

A manufacturing method in an embodiment of a first aspect according to the present invention for producing the semiconductor device in the above-mentioned embodiment shown in FIG. 9 is described next.

By the same processes (1) and (2) as those described above with reference to FIG. 2, (a) and (b), the interlayer insulating film 5, the wiring patterns 11 made of the metal wiring patterns 7 and the high-melting-point metal films 9, and the side walls 13 are produced on the wafer-shaped silicon substrate 1 on which production of the device separating oxide film 3 is completed.

In the same condition as that of the process (3) described above with reference to FIG. 2, (c), in an Ar sputter etching chamber of a multi-chamber sputtering apparatus for example, in vacuo, Ar sputter etching is carried out on the surface of the interlayer insulating film 5, second side walls 15 are produced, and continuously, after the completion of the Ar sputter etching, a CrSi thin film for a metal thin-film resistance element is produced continuously without breakage of the vacuum state.

Further, after production of the CrSi thin film, continuously without breakage of the vacuum state, a CrSiN film is produced on the CrSi thin-film. For example, with the use of a CrSi target of Si/Cr = 80/20 wt% used for producing the CrSi thin film, processing is carried out in a condition of: DC power: 0.7 kW; Ar+N₂ (mixture gas of argon and nitrogen): 85 sccm; pressure: 8.5 milliTorrs; processing time: 6 seconds. Thus, the CrSiN film is produced on the CrSi thin-film for a film thickness of approximately 50 Å. Next, the CrSiN film and the CrSi thin film are patterned, and thus, a laminated pattern made of the CrSiN film 25 and the CrSi thin-film resistance element 17 is produced.

The same as the above-described embodiment, since the CrSi thin-film resistance element 17 is electrically connected with the wiring patterns 11, it is not necessary to carry out metal oxide film removing processing for the surface of the CrSi thin-film resistance element 17 with hydrofluoric solution as in the prior art. Furthermore, since the top surface of the CrSi thin-film resistance element 17 is covered by the CrSiN film 25, the top surface of the CrSi thin-film resistance element 17 can be prevented from being oxidized even when the product is exposed to an atmosphere including oxygen such as the air.

After that, the passivation film 23 made of the silicon oxide film 19 and the silicon nitride film 21 is produced on the interlayer insulating film 5.

Generally speaking, a metal thin film has a high reactivity to oxygen, and thus, a resistance value thereof changes when it is left exposed to the air for a long duration, as well known.

According to the above-described second embodiment, since the CrSiN film 25 is produced on the top surface of the CrSi thin-film resistance element 17, it is possible to prevent the top surface of the CrSi thin-film resistance element 17b from being directly exposed to the air, and thus, it is possible to prevent the resistance value of the CrSi thin-film resistance element 17 from changing. There, since electrical connection between the CrSi thin film and the wiring patterns 11 is already completed in the stage in which the CrSi thin film for producing the CrSi thin-film resistance element 17 has been produced, the performance is never affected even though the new thin film is produced further on the CrSi thin film.

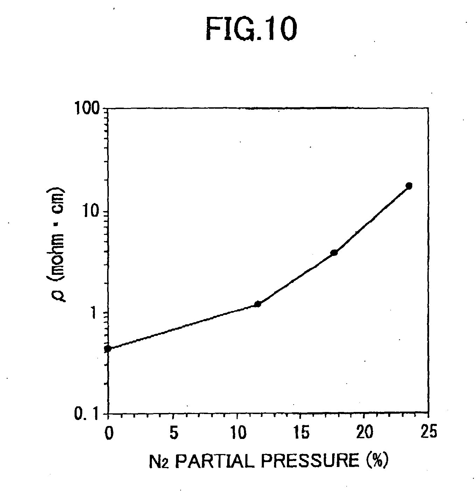

FIG. 10 shows a relationship between an N₂ partial pressure in a gas for producing the CrSiN film and the resistivity of the CrSiN film. The ordinate axis denotes the resistivity ρ (mohrm • cm) and the abscissa axis denotes the N₂ partial pressure (%). There, the CrSiN film was produced in a condition of; target: Si/Cr = 50/50 wt%; DC power: 0.7 kW; Ar+N₂: 85 sccm; pressure: 8.5 milliTorrs; and processing time: 6 seconds, and the N₂ partial pressure of the Ar+N₂ gas was adjusted.

The CrSiN film produced by a reactive sputter with addition of equal to or more than 18 % of N₂ partial pressure has a resistivity higher than that of a case where the gas without addition of N₂ at all (the N₂ partial pressure is 0 %), by equal to or more than ten times. Accordingly, when the CrSiN film is produced with a setting of 18 % or more of the N₂ partial pressure, the overall resistance value of the CrSi thin-film resistance element is substantially determined by the CrSi thin film even when the CrSiN film is produced directly on the CrSi thin-film resistance element. Thus, the CrSiN film hardly affects the resistance value. There, the upper limit of the N₂ partial pressure is on the order of 90 %. If the N₂ partial pressure is set above 90 %, the sputtering speed lowers much, thus production efficiency lowers, and thus, such a setting is not preferable.

It is possible to apply the CrSiN film itself as a metal thin-film resistance element when N₂ partial pressure is added on the order of a range between 6 and 11 %, for example, and the film is produced by a reactive sputter.

Further, although the CrSiN film 25 is produced on the CrSi thin-film resistance element in the above-mentioned embodiment, a CVD insulating film, for example, a silicon nitride film or such may be produced on the CrSi thin-film resistance element 17 instead. However, a CVD chamber is not connected to a common multi-chamber sputtering apparatus. Accordingly, it is necessary to purchase a corresponding new apparatus for producing such a CVD insulating film on the CrSi thin-film resistance element 17 continuously in vacuo, and thus, the manufacturing cost may be considerably affected.

In contrast thereto, when the CrSiN film 43 is produced on the CrSi thin-film resistance element 17 as in the above-mentioned embodiment, it is not necessary to purchase a new apparatus, and it is possible to produce the CrSiN film 43 acting as an acid-resistant cover for the CrSi thin-film resistance element 17 without breakage of vacuum state with the use of the existing multi-chamber sputtering apparatus.

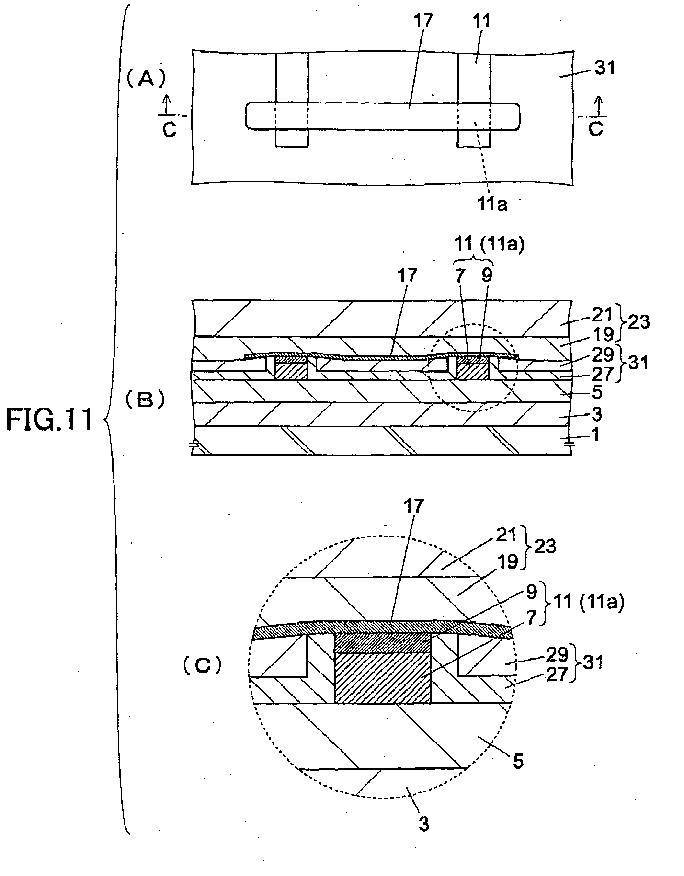

FIG. 11 shows an area having a metal thin-film resistance element in a first embodiment of a second mode of the semiconductor device according to the present invention. FIG. 11, (A) shows a plan view; FIG. 11, (B) shows a sectional view taken along a C-C position of FIG. 11, (A); and FIG. 11, (C) shows a magnified view of a portion defined by broken line in FIG. 11, (B). In FIG. 11, (A), a passivation film is omitted. The same reference numerals are given to parts having the same functions as those in FIG. 1, and detail description thereof is omitted.

On a silicon substrate 1, a device separating oxide film 3, an interlayer insulating film 5, a wiring pattern 11 made of a metal material pattern 7 and a high-melting-point metal film 9, are produced.

On the interlayer insulating film 5, a second insulating film 31, which is made of a plasma CVD oxide film 27 on a lower layer side and an SOG film 29 on an upper layer side, and is produced to have a metal thickness such as to expose the top surface of the wiring pattern 11 as a result of etch back processing being carried out after the both films are deposited, is produced.

A belt-shaped CrSi thin-film resistance element 17 is produced on the second insulating film 31 between the opposite pair of wiring patterns 11. Both end parts of the CrSi thin-film resistance element 17 extend over the second insulating films 31 produced in the vicinity of the respective side surfaces of the pair of wiring patterns 11, which side surfaces are those on the other side of the above-mentioned opposite side surfaces of these wiring patterns. The CrSi thin-film resistance element 17 and the wiring patterns 11 mutually intersect on electrodes 11a as shown in FIG. 11, (A).

A passivation film 23 made of a silicon oxide film 19 on a lower layer side and a silicon nitride film 21 on an upper layer side is produced (not shown in FIG. 11, (A)) on the interlayer insulating film 5 including the area having the CrSi thin-film resistance element 17.

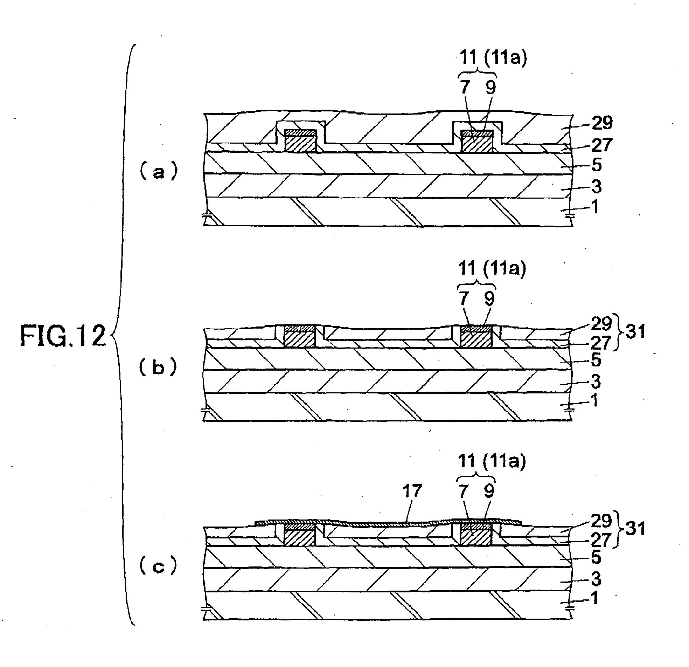

FIG. 12 shows a process sectional view for illustrating an embodiment of a second aspect of a manufacturing method according to the present invention. This embodiment is applied to manufacture the semiconductor device described above with reference to FIG. 11. With reference to FIGS. 11 and 12, the present embodiment is described now.
(1) By the same process as that (1) described 5 above with reference to FIG. 2, (a), the interlayer insulating film 5 is produced on the wafer-shaped silicon substrate 1 on which production of the device separating oxide film 3 and a transistor device or such (not shown), and the wiring patterns 11 made of the metal wiring patterns 7 and the high-melting-point metal films 5 are produced on the interlayer insulating film 5
   By a plasma CVD process for example, the plasma CVD oxide film 27 is produced to have a film thickness on the order of 2000 Å on the interlayer insulating film 5 including the areas having the wiring patters 11, and after that, the SOG film 29 is produced by SOG coating processing which is a well-known art (see FIG. 12, (a)).
(2) Etch back processing is carried out on the SOG film 29 and the plasma CVD oxide film 27 in such a manner as to expose the top surfaces of the wiring patterns 11. Thus, the second insulating film 31 made of the plasma CVD oxide film 27 and the SOG film 29 is produced (see FIG. 12, (b)).
(3) By the same condition as that of the above-mentioned process (3) described above with reference to FIG. 2, (c), Ar sputter etching processing is carried out on the second insulating film 31 including the areas of the wiring patterns 11, and, continuously the CrSi thin film for metal thin-film resistance element is produced continuously without breakage of the vacuum state after the completion of the Ar sputter etching processing. Then the CrSi thin film is patterned and thus, the CrSi thin-film resistance element 17 is produced (see FIG. 12, (c)).
(4) For example, by a plasma CVD process, the silicon oxide film 19 and the silicon nitride film 21 acting as the passivation film are produced in sequence on all the surface of the interlayer insulating film 5. Thus, the semiconductor device manufacturing process is completed (see FIG. 11).

The same as in the above-described embodiment described above with reference to FIG. 1 and FIG. 2, it is not necessary to carry out patterning by wet etching technology after production of the CrSi thin-film resistance element 17 in the embodiment of the semiconductor device described above with reference to FIG. 11 and the manufacturing method described above with reference to FIGS. 11 and 12. Further, since the contact surface of the CrSi thin-film resistance element 17 with the wiring pasterns 11 are not exposed to the air, it is possible to stably maintain a satisfactory electrical connection between the CrSi thin-film resistance element and the wiring patterns 11. Thus, it is possible to achieve miniaturization of the CrSi thin-film resistance element 17 and stabilization of the resistance value of the same, without increasing the number of required processes without regard to the film thickness of the CrSi thin-film resistance element 17.

Further, the same as in the embodiment described above with reference to FIGS. 1 and 2, since no connecting hole for electrically connecting between the CrSi thin-film resistance element 17 and the wiring patterns 11 is required, it is possible to shorten and simplify the process in comparison to a case where the connecting holes are produced. Also, variation of the resistance value of the metal thin-film resistance element and increase of the contact resistance with the electrodes do not occur which would otherwise occur due to degradation of step coverage of the metal thin-film resistance element due to existence of the connecting holes.

Further, since the second insulating film 31 is produced on the side surfaces of the wiring patterns, degradation of step coverage of the CrSi thin-film resistance element 17 due to steep steps at the side surfaces of the wiring patterns can be avoided.

Thus, it is possible to achieve stabilization of the resistance value of the CrSi thin-film resistance element 17 including the contact resistance with the electrodes 11a.

Further, since both end parts of the CrSi thin-film resistance element 17 extend to intersect the wiring patterns 11 on the electrodes 11a, it is possible to avoid variation of contact areas between the electrodes 11a and the CrSi thin-film resistance element 17 otherwise occurring due to misalignment between the wiring patterns 11 and the CrSi thin-film resistance element 17 or rounding of end parts of the CrSi thin-film resistance element 17. Thus, it is possible to obtain the further stabilized contact resistance.

Further, since the high-melting-point metal film 9 acting as the barrier film is inserted between the CrSi thin-film resistance element 17 and the metal material pattern 7, it is possible to reduce variation of the contact resistance between the CrSi thin-film resistance element 17 and the wiring pattern 11, and thus, it is possible to improve accuracy of the resistance value and the yield.

Furthermore, since the high-melting-point metal film 9 also acts as the reflection preventing film and also, it is possible to produce the high-melting-point metal film 9 without increasing the number of manufacture processes in comparison to the prior art, it is possible to stabilize the contact resistance between the metal thin-film resistance element and the wiring pattern while preventing increase of the manufacturing cost.

Further, as a result of carrying out the Ar sputter etching processing as mentioned above, it is possible to remove insulating substance from the top surface of the high-melting-point metal film 9 of the wiring pattern 11, and also, it is possible to improve foundation film dependence of the CrSi thin-film resistance element 17 produced in a subsequent process.

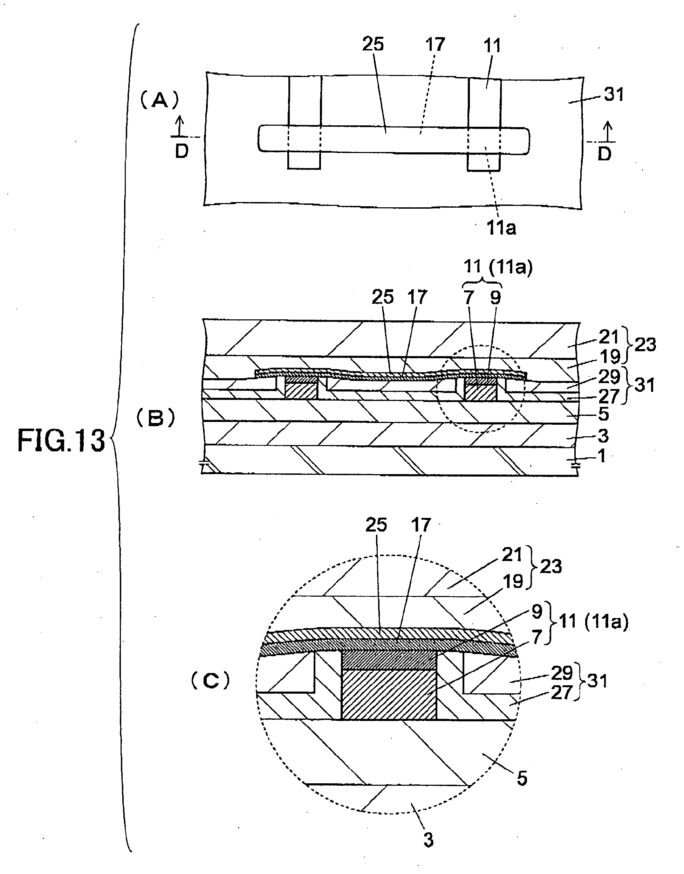

FIG. 13 shows an area having a metal thin-film resistance element in a second embodiment of the second mode of the semiconductor device according to the present invention. FIG. 13, (A) shows a plan view; FIG. 13, (B) shows a sectional view taken along a D-D position; and FIG. 13, (C) shows a magnified view of a portion defined by broken line in FIG. 13, (B). In FIG. 13, (A), a passivation film is omitted. The same reference numerals are given to parts having the same functions as those in FIG. 1, and detail description thereof is omitted.

On a silicon substrate 1, a device separating oxide film 3, an interlayer insulating film 5, wiring patterns 11 each made of a metal material pattern 7 and a high-melting-point metal film 9, and a second insulating film 31 made of a plasma CVD oxide film 27 and an SOG film 29 are produced.

A CrSi thin-film resistance element 17 is produced to intersect a pair of wiring patterns 11 on electrodes 11a, and extend over the second insulating film 31 across the surfaces of the electrodes 11a. On the top surface of the CrSi thin-film resistance element 17, a CrSiN film 25 is produced. CrSiO is not produced between the CrSi thin-film resistance element 17 and the CrSiN film 25.

A passivation film 23 made of a silicon oxide film 19 and a silicon nitride film 21 is produced on all the surface of the second insulating film 31.

A manufacturing method in an embodiment of a first aspect according to the present invention for producing the above-described embodiment shown in FIG. 13 is described next.

By the same processes (1) and (2) as those described above with reference to FIG. 12, (a) and (b), the interlayer insulating film 5, the wiring patterns 11 made of the metal wiring patterns 7 and the high-melting-point metal films 9, and the second insulating film 31 made of the plasma CVD oxide film 27 and the SOG film 29 are produced on the wafer-shaped silicon substrate 1 on which production of the device separating oxide film 3 is completed.

In the same condition as that of the process (3) described above with reference to FIG. 2, (c), in an Ar sputter etching chamber of a multi-chamber sputtering apparatus for example, in vacuo, Ar sputter etching is carried out on the surface of the interlayer insulating film 31, and continuously, after the completion of the Ar sputter etching, a CrSi thin film for the metal thin-film resistance element is produced continuously without breakage of the vacuum state.

Further, after production of the CrSi thin film, continuously without breakage of the vacuum state, a CrSiN film is produced on the CrSi thin-film in the condition the same as that of the manufacturing method described above with reference to FIG. 9.

After that, the CrSiN film and the CrSi thin film are patterned, and thus, a laminated pattern made of the CrSiN film 25 and the CrSi thin-film resistance element 17 is produced.

After that, a passivation film 23 made of the silicon oxide film 19 and the silicon nitride film 21 is produced on the second insulating film 31

According to the above-described embodiment, the same as the embodiment described above with reference to FIG. 9, since the CrSiN film 25 is produced on the top surface of the CrSi thin-film resistance element 17, it is possible to prevent the top surface of the CrSi thin-film resistance element 17 from being exposed to the air, and thus, it is possible to prevent the resistance value of the CrSi thin-film resistance element 17 from changing.

In the above-mentioned embodiment, as the second insulating film 31, one obtained as a result of the SOG film 29 being coated on the plasma CVD oxide film 27, and the SOG film 29 being then planarized as a result of etch back processing being carried out thereon is applied. However, the second insulating film which acts as a foundation of the metal thin-film resistance element 17 is not limited thereto. For example, one produced as a result of a CVD insulating film produced by an HDP (high-density-plasma) CVD process being etched back to have a film thickness such as to expose surfaces of the wiring patterns, one produced as a result of a deposited plasma CVD oxide film being polished to have a film thickness such as to expose surfaces of the wiring patterns by means of a CMP method or such may be applied instead.

Further, in the above-mentioned embodiment, the example where the TiN film is applied as the high-melting-point metal film 9 is shown. However, the high-melting-point metal film included in each of the wiring patterns is not limited thereto. For example, another material such as TiW, WSi or such may be applied as the high-melting-point metal film instead.

In the above-mentioned embodiment, the present invention is applied to the semiconductor device in which the single layer of the wiring patterns 11 are provided as metal wiring. However, the present invention is not limited thereto, and, the present invention may be applied to a semiconductor device having a multi-layer metal wiring structure. In this case, a metal wiring under the metal thin-film resistance element for making electrical connection from the metal thin-film resistance element may correspond to a metal wiring of any layer of the plurality of layers of metal wiring. However, in a case where the present invention is applied to a semiconductor device having such a multi-layer metal wiring structure, when the wiring pattern (metal wiring) under the metal thin-film resistance element, that is, the wiring pattern for making electrical connection from the metal thin-film resistance element corresponds to the wiring pattern of the top layer of the plurality of layers of metal wiring, it is possible to increase design freedom, for example, layout change of the metal thin-film resistance element can be achieved by layout change of the metal thin-film resistance element and the top layer wiring pattern. Further, by disposing the metal thin-film resistance element on an insulating film produced on the top layer wiring pattern, a final protection film made of an insulating material is produced on the metal thin-film resistance element. Thus, it is possible to reduce the film thickness of the insulating material on the metal thin-film resistance element, and to reduce film thickness variation, in comparison to a case where further another insulating film is produced on the metal thin-film resistance element in addition to the final protection film. As a result, when carrying out trimming processing by applying a laser beam to the metal thin-film resistance element, it is possible to reduce variation of laser interference in the insulating film on the metal thin-film resistance element and to reduce laser energy variation applied to the metal thin-film resistance element. Thus, it is possible to improve accuracy of the trimming. Further, it is possible to improve radiation capability with respect to temperature rise in the metal thin-film resistance element caused by laser beam application upon trimming processing.

Further, in the above-mentioned embodiment, as each wiring pattern 11, one in which the high-melting-point metal film 9 is produced on the wiring material pattern 7 is applied. However, the present invention is not limited thereto, and, as the wiring pattern, a metal material pattern having no high-melting-point metal film produced on the top thereof may be applied instead. In this case, when Al alloy is applied as the metal material pattern, a stiff natural oxide film is produced on the surface of the metal material pattern. Therefore, it is preferable to carry out a process of removing the natural oxide film from the surface of the metal material pattern, before producing the metal thin film for the metal thin-film resistance element. This natural oxide film removing process may be carried out as common processing as the above-mentioned Ar sputtering processing for the purpose of reducing aging variation of the resistance value of the metal thin-film resistance element. Further, the wiring pattern is not limited to the Al alloy, and a wiring pattern made of another metal material such as a Cu wiring produced by a so-called damascene processing or such may be applied for example, instead.

Further, in the above-mentioned embodiment, as the wiring pattern to obtain an electric potential of the CrSi thin-film resistance element 17, one made of the metal material pattern 7 and the high-melting-point metal film 9 is applied. However, instead of the metal material pattern 7, a polysilicon pattern may be applied

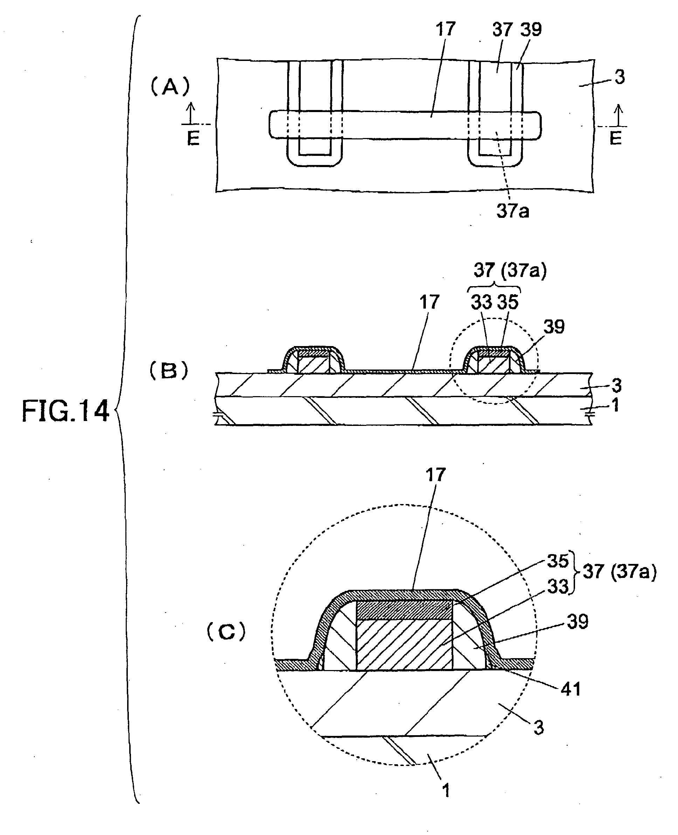

FIG. 14 shows an area having a metal thin-film resistance element according to a third embodiment of the first mode according to the present invention, (A) showing a plan view; (B) showing a front elevational sectional view taken along a E-E line of (A); and (C) showing a magnified view of a part defined by a broken line in (B). In FIG. 14, (A), a passivation film is omitted. The same reference numerals are given to parts having the same functions as those shown in FIG. 1, and detailed description thereof is omitted.

On a silicon substrate 1, a device separating oxide film 3 is produced. On an oxide film (not shown) produced on the polysilicon substrate 1 and on the device separating oxide film 3, wiring patterns 27 made of polysilicon patterns 33 and high-melting-point metal films 35 produced on the polysilicon patterns 33 respectively are produced. The high-melting-point metal film 35 is made of, for example, WSi or TiSi. In a transistor device producing area not shown, the wiring pattern 37 forms a gate electrode.

On side surfaces of each wiring pattern 37, side walls 39 made of insulating material, for example, CVD oxide films are produced. Second side walls 41 (omitted in FIG. 14, (A) and (B)) are produced on surfaces of the side walls 39 on the side of the device separating oxide film 3. The second side walls 41 are produced as a result of Ar sputter etching being carried out on the device separating oxide film 3 after the wiring patterns 37 and the side walls 39 are produced. The second side walls 41 include Ar as a component, and further include materials of the device separating oxide film 3, the side walls 39 and the high-melting-point metal film 35.

On surfaces of the side walls 39 between the pair of opposing wiring patterns 37, surfaces of the second side walls 41 and the device separating oxide film 3, a belt-shaped CrSi thin-film resistance element (metal thin-film resistance element) 17 is produced. Both end parts of the CrSi thin-film resistance element 17 extend over surfaces of the side walls 39 and the second side walls 41 produced on the side surfaces on the respective sides opposite to the side surfaces opposing between the pair of wiring pattern 37, and also extend over the device separating oxide film 3. The CrSi thin-film resistance element 17 and the wiring patterns 37 intersect each other. Parts at which the wiring patterns 37 are intersected by the CrSi thin-film resistance element 17 form electrodes 37a (see FIG. 14, (A)) .

Although not shown, an interlayer insulating film, a metal wiring pattern and a passivation film are produced on the device separating oxide film interlayer film 3 including the areas having the CrSi thin-film resistance element 17, the wiring patterns 37, and the side walls 39 and 41.

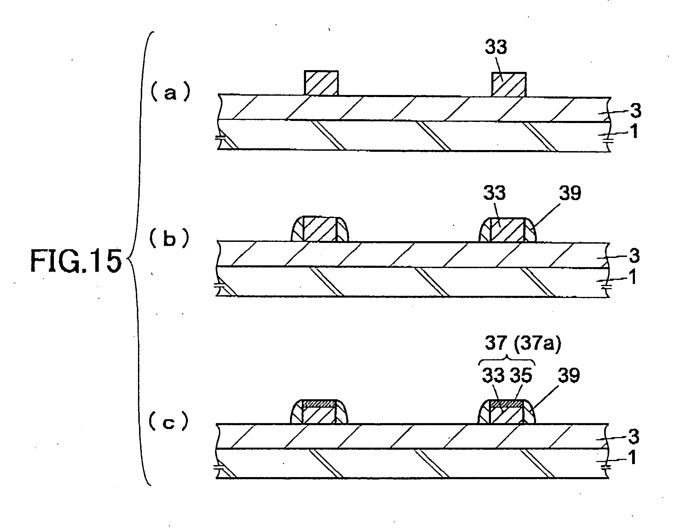

FIG. 15 shows a process sectional view for illustrating a second embodiment of the first aspect of a manufacturing method according to the present invention. This embodiment is applied to manufacture the embodiment of semiconductor device described above with reference to FIG. 14. With reference to FIGS. 14 and 15, the embodiment of the manufacturing method is described.
(1) The device separating film 3 is produced on the silicon substrate 1, and an oxide film (not shown) such as a gate oxide film for a transistor is produced for the surface of the silicon wafer in an area other than the device separating oxide film 3. After that, a polysilicon film is produced on all the surface of the silicon substrate 1. For example, simultaneously with the production of the gate electrode of the transistor, the polysilicon patterns 33, having undergone resistance reducing processing, are produced (see FIG. 15, (a)).
(2) With the use of a plasma CVD process for example, a plasma CVD oxide film is produced for a film thickness on the order of 2000 Å on all the surface of the silicon substrate 1 including the device separating oxide film 3 produced area. After that, etch back processing is carried out, and thus, the side walls 39 (see FIG. 15, (b)) made of the plasma CVD oxide film are produced on the side surfaces of the polysilicon patterns 33.
(3) On all the surface of the silicon substrate 1 including the polysilicon patterns 33 and the side walls 39, a high-melting-point metal film is produced, the polysilicon patterns 33 are transformed into salicide, and a high-melting-point metal film 35 made of TiSi, WSi or such is produced on the polysilicon patterns 33, and each wiring patterns 37 are produced (see FIG. 15, (c)).
(4) In the same condition as the above-mentioned process (3) described above with reference to FIG. 2, (c), Ar sputter etching is carried out on the device separating oxide film 3 including the areas on which the wiring patters 37 and the side walls 39 are produced, thus the second side walls 41 are produced, and, continuously, a CrSi thin film for the metal thin-film resistance element 17 is produced continuously without breakage of the vacuum state. The CrSi thin film is then patterned, and thus the CrSi thin-film resistance element 17 is produced (see FIG. 14).

Also in this embodiment, the same as in the embodiment described above with reference to FIGS. 1 and 2, it is not necessary to carry out patterning by wet etching technology after the CrSi thin-film resistance element 17 is patterned.. Further, the contact surface of the CrSi thin-film resistance element 17 with the wiring pattern 37 is not exposed to the atmospheric air. Accordingly, it is possible to obtain sufficient electrical connection between the CrSi thin-film resistance element 17 and the wiring pattern 37 stably. Thereby, without regard to the film thickness of the CrSi thin-film resistance element 17, it is possible to achieve miniaturization and stabilization of the resistance value of the CrSi thin-film resistance element 17 without increasing the number of manufacturing processes required.

Further, since the high-melting-point metal film 35 acting as the barrier film is inserted between the CrSi thin-film resistance element 17 and the polysilicon pattern 33, it is possible to reduce variation of the contact resistance between the CrSi thin-film resistance element 17 and the wiring pattern 37, and thus, it is possible to improve accuracy of the resistance value and the yield.

Further, the high-melting-point metal film 35 also contributes to resistance reduction of the polysilicon patterns 33, also it is possible to produce the high-melting-point metal film 35 without increasing the number of manufacture processes in comparison to the prior art, and it is possible to stabilize the contact resistance between the metal thin-film resistance element and the wiring pattern while preventing increased of the manufacturing costs.

Further, as a result of carrying out the Ar sputter etching processing before producing the metal thin film, it is possible to reduce variation of the resistance value otherwise occurring due to difference in the foundation film which differs depending on a time having elapsed from the previous process, depending on each particular product, or such.

Further, in a case where a transistor device having an LDD (lightly doped drain) structure such as a transistor device having a side wall on a side surface of a polysilicon pattern forming a gate electrode is produced on the common silicon substrate, it is possible to also produce the side walls 39 on the side surfaces of each wiring patterns 37 on the area on which the CrSi thin-film resistance element 17 is produced when the side wall is produced on the side surface the polysilicon pattern forming the gate electrode as mentioned above. Thus, it is possible to avoid increase in the number of manufacture processes.

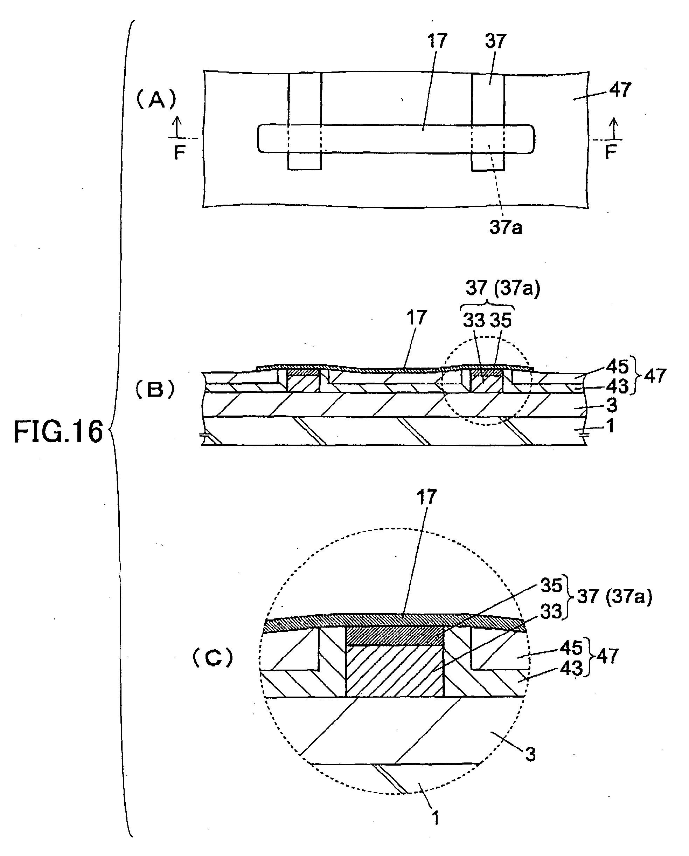

FIG. 16 shows an area having a metal thin-film resistance element according to a third embodiment of the second mode according to the present invention, (A) showing a plan view; (B) showing a front elevational sectional view taken along a F-F line of (A); and (C) showing a magnified view of a part defined by a broken line in (B). In FIG. 16, (A), a passivation film is omitted. The same reference numerals are given to parts having the same functions as those shown in FIG. 1 and FIG. 14, and detailed description thereof is omitted.

On a silicon substrate 1, a device separating oxide film 3 and wiring patterns 37 each made of polysilicon patterns 33 and high-melting-point metal films 35 are produced.

On the device separating oxide film 3, a second insulating film 47 made of a plasma CVD oxide film 43 on a lower layer side and an SOG film on an upper layer side, and produced to have a film thickness such as to expose the top surfaces of the wiring patterns 37 as result of etch back processing being carried out after both the films are deposited, are produced.

On the second insulting film 47 between the opposite pair of wiring patterns 37, a belt-shaped CrSi thin-film resistance element 17 is produced. Both end parts of the CrSi thin-film resistance element 17 extend over the second insulating film 47 produced in the vicinity of the side surfaces of the pair of wiring patterns 37, which side surfaces are located opposite to the side surfaces of the pair wiring patterns 37 opposing one another, and the CrSi thin-film resistance element 17 and the wiring patterns 37 intersect each other at electrodes 37a.

Although not shown, an interlayer insulating film, a metal wiring pattern and passivation film are produced on the second insulating films 47 including the areas in which the CrSi thin-film resistance element 17 and the wiring patterns 37 are produced.

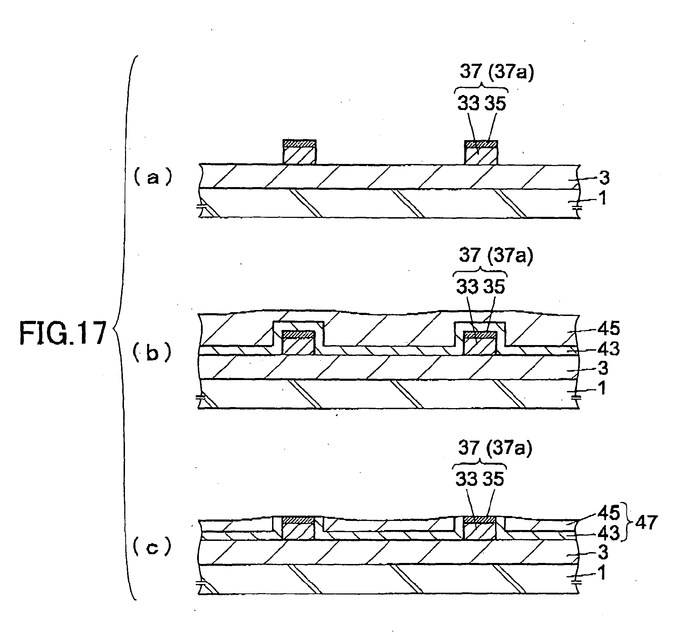

FIG. 17 shows a process sectional view for illustrating a fourth embodiment of the second aspect of a manufacturing method according to the present invention. This embodiment is applied to manufacture the embodiment of semiconductor device described above with reference to FIG. 16. With reference to FIGS. 16 and 17, the embodiment of the manufacturing method is described.
(1) The device separating oxide film 3 is produced on the silicon substrate 1, and an oxide film (not shown) such as a gate oxide film for a transistor is produced on the surface of the silicon wafer in an area other than that of the device separating oxide film 3. After that, a polysilicon film is produced on all the surface of the silicon substrate 1. For example, simultaneously with production of the gate electrode of the transistor, the polysilicon patterns 33, having undergone resistance reducing processing, are produced. On all the surface of the silicon substrate 1 including the polysilicon patterns 33, a high-melting-point film is produced, the polysilicon patterns 33 are transformed into salicide, the high-melting-point metal film 35 made of TiSi, WSi or such is produced on the polysilicon patterns 33, and thus, the wiring patterns 37 are produced (see FIG. 17, (a)).
(2) With the use of a plasma CVD process for example, a plasma CVD oxide film 43 is produced for a film thickness of on the order of 2000 Å on all the surface of the silicon substrate 1 including the areas in which the device separating oxide film 3 and the wiring patterns 37 are produced. After that, SOG coating processing which is a well-known art is carried out and thus, the SOG film 45 is produced (see FIG. 17, (b)).
(3) Etch back processing is carried out on the SOG film 45 and the plasma CVD oxide film 43 so that the top surfaces of the wiring patterns 37 are exposed, and thus, the second insulating film 47 made of the plasma CVD oxide film 43 and the SOG film 45 is produced (see FIG. 17, (c)).
(4) In the same condition as the above-mentioned process (3) described above with reference to FIG. 2, (c), Ar sputter etching is carried out on the second insulating film 47 including the areas in which the wiring patterns 37 are produced, then a CrSi thin film for the metal thin-film resistance element is produced continuously without breakage of the vacuum state after the completion of the Ar sputter etching processing. Thus, the CrSi thin film is produced for the CrSi thin-film resistance element 17. Then, the CrSi thin film is patterned, and thus the CrSi thin-film resistance element 17 is produced (see FIG. 16).

After that, the interlayer insulating film, the metal wiring pattern, the passivation film and so forth are produced.

Also in this embodiment, the same as the embodiment described above with reference to FIGS. 1 and 2, it is not necessary to carry out patterning by wet etching technology after the CrSi thin-film resistance element 17 is patterned. Further, the contact surface of the CrSi thin-film resistance element 17 with the wiring pattern 37 is not exposed to the atmospheric air. Accordingly, it is possible to obtain sufficient electrical connection between the CrSi thin-film resistance element 17 and the wiring pattern 37 stably. Thereby, without regard to the film thickness of the CrSi thin-film resistance element 17, it is possible to achieve miniaturization and stabilization of the resistance value of the CrSi thin-film resistance element 17 without increasing the number of manufacturing processes required.

Further, the same as in the embodiment described above with reference to FIGS. 14 and 15, the advantage obtained as a result of the high-melting-point metal film 35 acting as the barrier film being inserted between the CrSi thin-film resistance element 17 and the polysilicon pattern 33, the advantage obtained as a result of the high-melting-point metal film 35 contributing resistance reduction of the polysilicon patterns 33, and the advantage obtained from the Ar sputter etch being carried out before the metal thin film for the CrSi thin-film resistance element is produced, are also obtained.

Further, the second insulating film 47 produced to have the film thickness to expose the surfaces of the wiring patterns 37 on the device separating oxide film 3 has an effect to omit or reduce planarization processing carried out on the interlayer insulating film produced over the second insulating film 47.

Also in the embodiment of the semiconductor device described above with reference to FIGS. 14 and 15 and in the embodiment of the semiconductor device described above with reference to FIGS. 16 and 17, the CrSiN film may be produced on the CrSi thin-film resistance element 17, the same as in the embodiment described above with reference to FIG. 9 and the embodiment described with reference to FIG. 13.

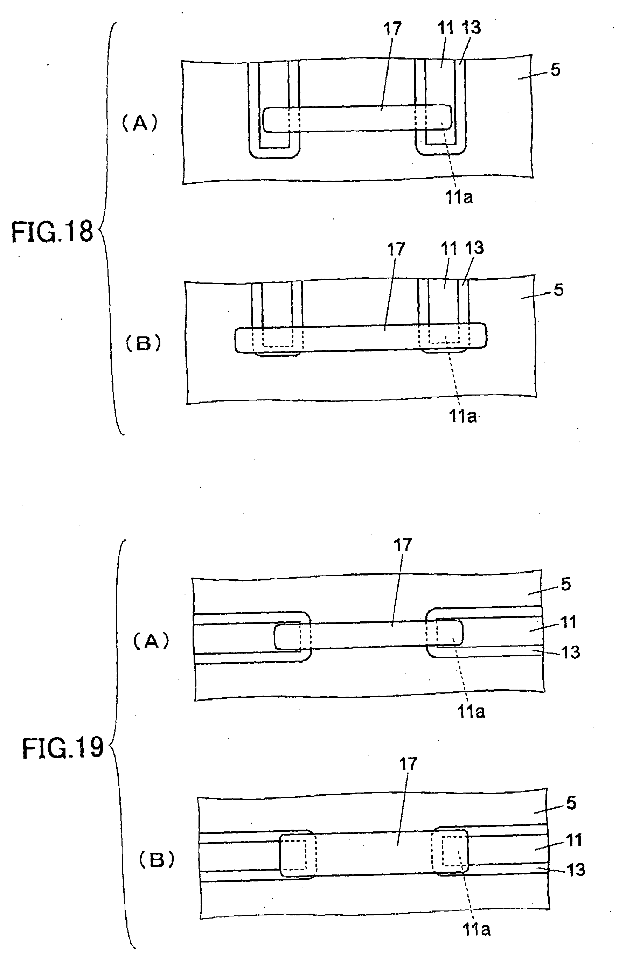

In the above-mentioned embodiments, the CrSi thin-film resistance element 17 and the wiring patterns 11 or 37 intersect each other. However, the present invention is not limited thereto. Merely end parts of the metal thin-film resistance element may be disposed on the wiring patterns, or end parts of the wiring patterns may be deposed below the metal thin-film resistance element. For example, with reference to the embodiment of the first mode described above with reference to FIG. 1, description is made next therefor. As shown in a plan view shown in FIG. 18, (A), end parts of the CrSi thin-film resistance element 17 may be disposed on the wiring patterns 11. Alternatively, as shown in a plan view shown in FIG. 18, (B), end parts of the wiring patterns 11 may be disposed below the CrSi thin-film resistance element 17.

Furthermore, the metal thin-film resistance element should not be necessarily disposed to extend perpendicular to the wiring patterns. Shapes, directions and arrangements of the metal thin-film resistance element and the wiring patterns are not limited to the embodiments. For example, as shown in a plan view shown in FIG. 19, (A) or (B), the metal thin-film resistance element and the wiring patterns may be disposed in mutually parallel relationship.

In the above-mentioned embodiments and samples shown in FIGS. 1 through 19, examples in which CrSi is applied as material of the metal thin-film resistance element are shown. However, the present invention is not limited thereto. For example, as material of the metal thin-film resistance element, another material may be applied, for example, NiCr, TaN, CrSi₂, CrSiN, CrSi, CrSiO or such.

A metal thin-film resistance element included in a semiconductor device according to the present invention, or a metal thin-film resistance element produced according to a manufacturing method according to the present invention may be applied to a semiconductor device having an analog circuit, for example.

Embodiments of a semiconductor device having an analog circuit applying a metal thin-film resistance element according to the present invention are described next.

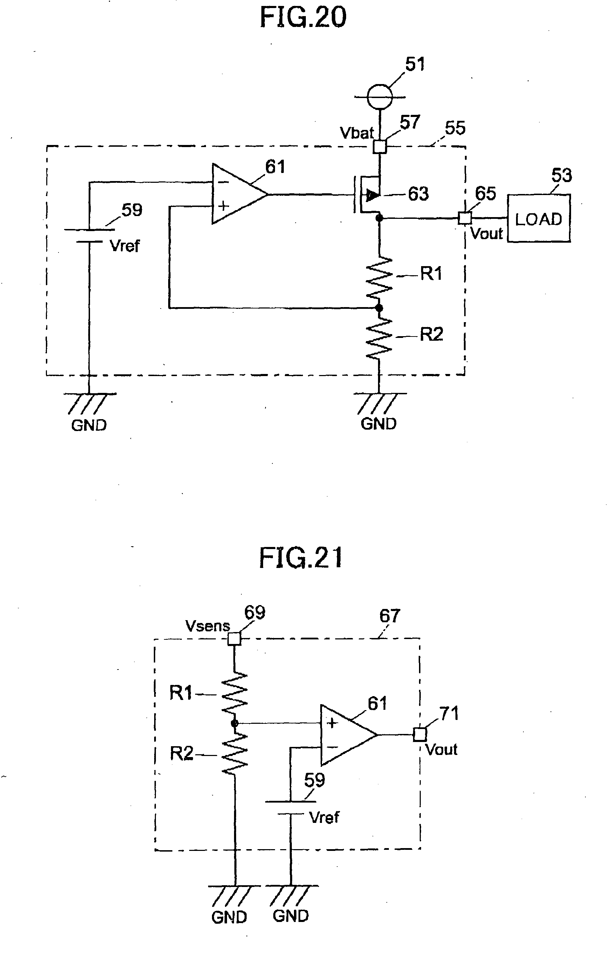

FIG. 20 shows a circuit diagram of one embodiment of a semiconductor device including an analog circuit, i.e., a constant voltage generating circuit.

For the purpose of supplying a power to a load 53 stably from a direct-current power source 51, the constant voltage generating circuit 55 is provided. The constant voltage generating circuit 55 includes an input terminal (Vbat) 57 to which the direct-current power source is connected; a reference voltage generating circuit (Vref) 59, an operational amplifier (comparison circuit) 61; a P-channel MOS transistor (abbreviated as PMOS, hereinafter) acting as an output driver; dividing resistance devices R1, R2; and an output terminal (Vout) 65.

In the operational amplifier 61, an output terminal is connected to a gate electrode of the PMOS 63; a reference voltage Vref is applied to an inverted input terminal (-) by the reference voltage generating circuit 59; a voltage divided by the resistance elements R1 and R2 is applied to the non-inverted input terminal (+); and thus, control is made such that the R1 and R2 divided voltage may become equal to the reference voltage Vref.

FIG. 21 shows a circuit diagram showing another embodiment of a semiconductor device including an analog circuit, i.e., a voltage detecting circuit.

In a voltage detecting circuit 67, a reference voltage generating circuit 59 is connected to an inverted input terminal (-) of an operational amplifier 61, and thus, a reference voltage Vref is applied thereto. A voltage input via an input terminal (Vsens) 69 to be measured is divided by dividing resistance elements R1 and R2, and then, is applied to a non-inverted input terminal (+). An output of the operational amplifier 61 is output externally via an output terminal (Vout) 71.

In the voltage detecting circuit 67, when the voltage at the terminal to measure is high, and thus, the voltage divided by the dividing resistance elements R1 and R2 is higher than the reference voltage Vref, the operational amplifier 61 maintains an H level in its output. On the other hand, when the voltage at the terminal to measure lowers, and thus, the voltage divided by the dividing resistance elements R1 and R2 becomes lower than the reference voltage Vref, the operational amplifier 61 maintain an L level.

Generally speaking, in the constant voltage generating circuit shown in FIG. 20 or the voltage detecting circuit shown in FIG. 21, the reference voltage Vref from the reference voltage generating circuit may vary due to a variation of a manufacturing process. In order to respond to such a variation, the resistance values of the dividing resistance elements may be adjusted as a result of applying, as each dividing resistance element, a resistance element circuit (referred to as a dividing resistance circuit) in which a resistance value is adjustable as a result of a fuse of a fuse element being brown.

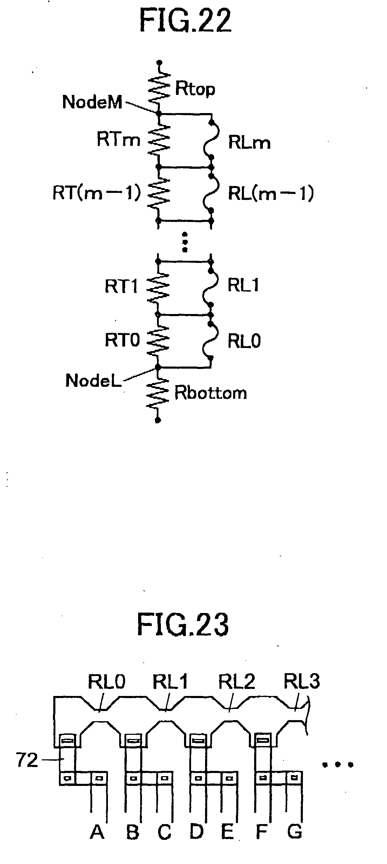

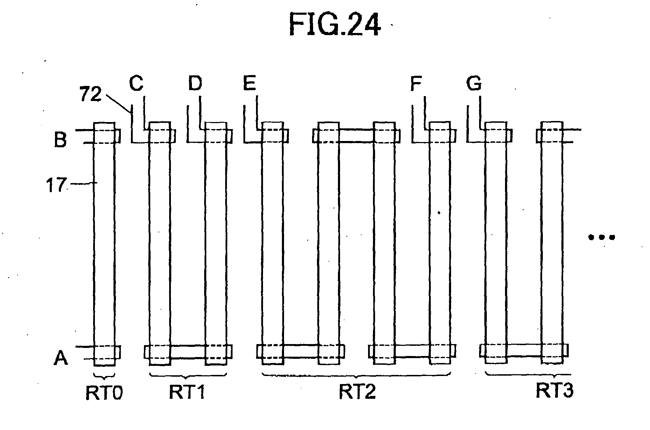

FIG. 22 shows one example of the dividing resistance circuit to which a metal thin-film resistance element according to the present invention is applicable FIG. 23 and FIG. 24 show layout diagrams showing layouts in the dividing resistance circuit. FIG. 23 shows an example of a layout of a fuse element part. FIG. 24 shows an example of a layout of a resistance element part.

As shown in FIG. 22, a resistance element Rbottom, m+1 (m denoting a positive integer) resistance elements RT0, RT1, RT2, ..., RTm, and a resistance element Rtop are connected in series. For each of the resistance elements RT0, RT1, ..., RTm, a respective one of fuse elements RL0, RL1, ..., RLm is connected in parallel.

As shown in FIG. 23, each of the fuse elements RL0, RL1, ..., RLm is produced of a polysilicon pattern having a sheet resistance in a range between 20 Ω and 40 Ω.

Resistance values of the resistance elements RT0, RT1, ..., RTm are set to increase in a manner of a binary notation from the side of the resistance element Rbottom. That is, each resistance element RTn has a resistance value which is 2° times a resistance value (regarded as a unit value) of the resistance element RT0.

For example, as shown in FIG. 24, with the use of a CrSi thin-film resistance element 17 made of a CrSi thin film, the resistance element RT0 is made of the single CrSi thin-film resistance element 17 as a unit resistance; and each resistance element RTn is made of the 2ⁿ CrSi thin-film resistance elements 17. As each CrSi resistance element 17, one shown in FIG. 1, 9, 11, 13, 14 or 16 is applied, for example.

In FIG. 23 and FIG. 24, respective electrical connections are provided between reference signs A-A; between reference signs B-B; between reference signs C-C; between reference signs D-D; between reference signs E-E; between reference signs F-F; and between reference signs G-G, by metal wiring pattern.

Thus, in the dividing resistance circuit for which an accuracy of a ratio between the resistance elements is important, in order to increase an accuracy of production in a manufacture process, unit resistance elements each including a pair of the resistance element and the fuse element are disposed in a manner of a ladder (see FIG. 22).

In such a dividing resistance circuit, any of the fuse elements RL0, RL1, ..., RLm may be brown by a laser beam, and thus a desired series resistance value is obtainable.

Since miniaturization of the resistance element and stabilization of the resistance value can be achieved in the metal thin-film resistance element included in the semiconductor device according to the present invention, it is possible to reduce an area required for producing the dividing resistance circuit and also to improve the accuracy of the output voltage.

In a case where the dividing resistance circuit shown in FIG. 22 is applied to the dividing resistance elements R1 and R1 of the constant voltage generating circuit shown in FIG. 20, the end terminal of the resistance element Rbottom is grounded, and the end terminal of the resistance element Rtop is connected to the drain of the PMOS 71, for example. Further, the terminal NodeL between the resistance elements Rbottom and RT0 or the terminal NodeM between the resistance elements Rtop and RTm is connected to the non-inverted input terminal of the operational amplifier 61.

Since the accuracy of the output voltage of the dividing resistance elements R1 and R1 can be improved as a result of the dividing resistance circuit in which the metal thin-film resistance elements according to the present invention are applied being applied, it is possible to improve stabilization of the output voltage of the constant voltage generating circuit. Further, as a result of the area required to produce the dividing resistance circuit being able to be reduced, the area required to produce the constant voltage generating circuit 55 can be reduced accordingly.

In a case where the dividing resistance circuit shown in FIG. 22 is applied to the dividing resistance elements R1 and R1 of the voltage detecting circuit shown in FIG. 21, the end terminal of the resistance element Rbottom is grounded, and the end terminal of the resistance element Rtop is connected to the input terminal 77, for example. Further, the terminal NodeL between the resistance elements Rbottom and RT0 or the terminal NodeM between the resistance elements Rtop and RTm is connected to the non-inverted input terminal of the operational amplifier 61.

Since the accuracy of the output voltage of the dividing resistance elements R1 and R1 can be improved as a result of the dividing resistance circuit in which the metal thin-film resistance elements according to the present invention are applied being applied, it is possible to improve the accuracy of the voltage detecting capability of the voltage detecting circuit 67. Further, as a result of the area required to produce the dividing resistance circuit being reduced, the area required to produce the voltage detecting circuit 67 can be reduced accordingly.

However, a semiconductor device in which the dividing resistance circuit in which the metal thin-film resistance elements according to the present invention are applicable is not limited to the semiconductor device including the constant voltage generating circuit or the semiconductor device including the voltage detecting circuit. It can be applied also to any other semiconductor circuit including the dividing resistance circuit. Further, a semiconductor device in which the metal thin-film resistance element is applicable is not limited to the semiconductor device including the dividing resistance circuit. It can be applied also to any other semiconductor device including the metal thin-film resistance element. For example, a metal thin-film resistance element may be applied as a resistance element applied to adjust a resistance value as a result of laser light being applied to the resistance element itself so as to cut or alter the quality thereof.

Thus, the embodiments of the present invention have been described. However, the present invention is not limited thereto, the size, shape, material, arrangement and so forth in these embodiments are merely for examples, and various changes may be made without departing from the scope of the present invention recited in the claims below.

The present application is based on Japanese Priority Application No. 2004-040910 filed on February 18, 2004, the entire contents of which are hereby incorporated herein by reference.

## Claims

1. A semiconductor device comprising:
an insulating film;
a metal thin-film resistance element;
a wiring pattern formed on said insulating film, a part of which forms an electrode for electrically connecting with said metal thin-film resistance element; and
a first side wall produced at least on a side surface of said electrode of said wiring pattern, and made of an insulation material, wherein:
said metal thin-film resistance element is produced over from a top surface of said electrode through a surface of the insulating film across a surface of said first side wall.

2. The semiconductor device as claimed in claim 1, wherein:
a second side wall including Ar is produced on a surface of said first side wall on the side of said insulating film.

3. A semiconductor device comprising:
a first insulating film;
a metal thin-film resistance element;
a wiring pattern formed on said first insulating film; and
a second insulating film on said first insulating film with a film thickness such that a top surface of said wiring pattern may be exposed, wherein:
said metal thin-film resistance element is produced over from a top surface of said electrode through a surface of said insulating film.

4. The semiconductor device as claimed in claim 1, 2 or 3, wherein:
a part of said metal thin-film resistance element intersects said wiring pattern on said electrode.

5. The semiconductor device as claimed in claim 1, 2, 3 or 4, wherein:
a film thickness of said metal thin-film resistance element is in a range of from 5 to 1000 Å.

6. The semiconductor device as claimed in claim 1, 2, 3, 4 or 5, wherein:
said wiring pattern comprises a metal material pattern and a high-melting-point metal film produced at least on a top surface of said metal material pattern.

7. The semiconductor device as claimed in any one of the preceding claims, wherein:
said wiring pattern comprises a polysilicon pattern and a high-melting-point metal film produced at least on a top surface of said polysilicon pattern.

8. The semiconductor device as claimed in any one of the preceding claims, further comprising:
a metal nitride film covering a top surface of said metal thin-film resistance element, wherein:
no metal oxide film is produced between a top surface of said metal thin-film resistance element and said metal nitride film.

9. The semiconductor device as claimed in any one of the preceding claims, wherein:
said wiring pattern comprises a wiring pattern of a top layer.

10. A semiconductor device comprising:
a dividing resistance circuit in which a voltage output is obtained as a result of a voltage being divided by means of a plurality of resistance elements, and the voltage output is adjustable as a result of a fuse element being blown out, wherein:
said resistance elements comprise metal thin-film resistance elements as claimed in any one of the preceding claims.

11. A semiconductor device comprising:
a voltage detecting circuit comprising:
a dividing resistance circuit for supplying a divided voltage as a result of dividing an input voltage;
a reference voltage generating circuit for supplying a reference voltage; and
a comparison circuit for comparing between the divided voltage from said dividing resistance circuit and the reference voltage from said reference voltage generating circuit, wherein:
said dividing resistance circuit comprises a dividing resistance circuit as claimed in claim 10.

12. A semiconductor device comprising:
a constant voltage generating circuit comprising:
an output driver controlling an output of an input voltage;
a dividing resistance circuit for supplying a divided voltage as a result of dividing the output voltage;
a reference voltage generating circuit for supplying a reference voltage; and
a comparison circuit for comparing between the divided voltage from said dividing resistance circuit and the reference voltage from said reference voltage generating circuit, and controlling said output driver according to a comparison result, wherein:
said dividing resistance circuit comprises a dividing resistance circuit as claimed in claim 10.

13. A method for manufacturing a semiconductor device comprising a metal thin-film resistance element and an insulating film, comprising:
producing a wiring pattern on said insulating film, a part of said wiring pattern comprising an electrode providing electrical connection with said metal thin-film resistance element;
producing an insulating material layer on said insulating film including an area in which said wiring pattern is produced, and then, carrying out etch back processing on said insulating material layer and producing a side wall on a side surface of said wiring pattern:
producing a metal thin film on said insulating film including an area in which said wiring pattern and said side wall are produced; and
patterning said metal thin film to leave it over from a top surface of said electrode through said insulating film across a surface of said side wall, so as to produce said metal thin-film resistance element.

14. A method for manufacturing a semiconductor device comprising a metal thin-film resistance element and a first insulating film, comprising:
producing a wiring pattern on said first insulating film, a part of said wiring pattern comprising an electrode providing electrical connection with said metal thin-film resistance element;
producing a second insulating film on said first insulating film with a film thickness such that a top surface of said wiring pattern is exposed;
producing a metal thin film on said wiring pattern and said second insulating film; and
patterning said metal thin film to leave it over from a top surface of said electrode through said second insulating film, so as to produce said metal thin-film resistance element.

15. The semiconductor device manufacturing method as claimed in claim 13 or 14 wherein:
the metal thin film produced has a film thickness in a range of from 5 to 1000 Å.

16. The semiconductor device manufacturing method as claimed in claim 13, 14 or 15, wherein:
before producing the metal thin film, Ar sputter etching processing is carried out.

17. The semiconductor device manufacturing method as claimed in claim 13, 14, 15 or 16, wherein:
the Ar sputter etching processing is carried out for a film thickness corresponding to a thermally-oxidized film etching amount of equal to or greater than 25 Å.

18. The semiconductor device manufacturing method as claimed in any one of claims 13 to 17, wherein:
said wiring pattern comprises a metal material pattern and a high-melting-point metal film produced at least on a top surface of said metal material pattern.

19. The semiconductor device manufacturing method as claimed in any one of claims 13 to 18 wherein:
said wiring pattern comprises a polysilicon pattern and a high-melting-point metal film produced at least on a top surface of said polysilicon pattern.

20. The semiconductor device manufacturing method as claimed in any one of claims 13 to 19, wherein:
said high-melting-point metal film produced has a metal thickness in a range of from 500 to 3000 Å.

21. The semiconductor device manufacturing method as claimed in any one of claims 13 to 20, wherein:
metal nitride film is produced on the metal thin film in an oxygen free atmosphere continuously after the metal thin film is produced in the oxygen free atmosphere; and
said metal nitride film and said metal thin film are patterned so that a laminated pattern comprising the metal nitride film pattern and the metal thin-film resistance element is produced.

22. The semiconductor device manufacturing method as claimed in any one of claims 13 to 21, wherein:
a nitride partial pressure in a sputtering gas when said metal nitride film is produced is in a range of from 18 to 90%.

23. The semiconductor device manufacturing method as claimed in any one of claims 13 to 22, wherein:
said wiring pattern comprises a wiring pattern in a top layer.
